# EUROPEAN PATENT APPLICATION

(11) **EP 4 198 685 A1**
(43) Date of publication of application: **21.06.2023**
(21) Application number: 21889555.5
(22) Date of filing: 03.11.2021
(51) Int. Cl.: G06F 1/20, G06F 1/16, H05K 7/20, G09F 9/30

(54) **ELECTRONIC DEVICE COMPRISING FLEXIBLE DISPLAY**

(30) Priority: 05.11.2020 KR 20200146959
(71) Applicant: Samsung Electronics Co., Ltd., Suwon-si, Gyeonggi-do 16677 (KR)
(72) Inventor: CHUNG, Haein, Suwon-si, Gyeonggi-do 16677 (KR); KANG, Dongku, Suwon-si, Gyeonggi-do 16677 (KR); KOO, Kyungha, Suwon-si, Gyeonggi-do 16677 (KR); PARK, Yoonsun, Suwon-si, Gyeonggi-do 16677 (KR); SONG, Yongjae, Suwon-si, Gyeonggi-do 16677 (KR)
(74) Representative: Gulde & Partner
(86) International application number: PCT/KR2021/015806
(87) International publication number: WO 2022/098090

(57) **Abstract**

An electronic device according to an embodiment includes a first structure, a second structure coupled to the first structure so as to slide, a flexible display that is disposed on the second structure and that includes a first region that forms a front surface of the electronic device and a second region that extends from the first region, a circuit board that is coupled to the first structure and that has a heat generating part disposed thereon, and a heat radiating member that is disposed to face the circuit board and that diffuses heat generated from the heat generating part. The electronic device includes a first state in which the second region is located in the first structure and a second state in which at least a portion of the second region forms the front surface of the electronic device together with the first region. The heat radiating member moves together with the second structure when the electronic device is changed to the first state and the second state.

## Description

### [Technical Field]

Various embodiments of the disclosure described herein relate to an electronic device including a flexible display.

### [Background Art]

An electronic device may include a flexible display. The electronic device may extend a display region visually exposed on an outer surface of the electronic device. For example, the flexible display may be disposed in the electronic device so as to be curved, foldable, or rollable.

### [Disclosure]

### [Technical Problem]

The electronic device may generate heat while consuming electric current during operation of heat sources, such as an application processor (AP), a power charging circuit, a communication module, and the like, which are mounted on a circuit board. The electronic device may include a heat radiating plate and may spread or radiate the heat generated from the heat generating elements.

Embodiments of the disclosure provide a heat radiating structure for effectively spreading heat to the outside of a rollable electronic device (or, a slidable electronic device) in an open state of the rollable electronic device (or, the slidable electronic device).

### [Technical Solution]

An electronic device according to an embodiment of the disclosure includes a first structure, a second structure coupled to the first structure so as to slide, a flexible display that is disposed on the second structure to move together with the second structure and that includes a first region that forms a front surface of the electronic device and a second region that extends from the first region, a circuit board that is coupled to the first structure and that has a heat generating part disposed thereon, and a heat radiating member that is disposed to face the circuit board and that diffuses heat generated from the heat generating part and partially overlaps the heat generating part when the front surface of the electronic device is viewed from above. The electronic device includes a first state in which the second region is located in the first structure and a second state in which at least a portion of the second region forms the front surface of the electronic device together with the first region. When the electronic device is changed to the first state and the second state by the sliding of the second structure, at least a portion of the heat radiating member moves together with a portion of the second structure in a direction of the sliding.

An electronic device according to an embodiment of the disclosure includes a first structure including a case and a bracket disposed in the case, a second structure that is connected to the first structure so as to slide and that surrounds at least a portion of the bracket, a flexible display that is disposed on the second structure and that moves together with the second structure, the flexible display including a first region that forms a front surface of the electronic device and a second region that extends from the first region such that at least a portion of the second region is accommodated in a space between the bracket and the case, a roller that is disposed on one side of the bracket so as to be rotatable about a rolling axis and that rotates a portion of the second structure, a circuit board that is fixed to the first structure to face the bracket and that has a heat generating part disposed on at least a portion of the circuit board, and a heat radiating member that is disposed between the bracket and the circuit board and that makes contact with the heat generating part and moves relative to the circuit board while making contact with the heat generating part depending on the sliding of the second structure. The electronic device includes a first state in which the second region is located in the case and a second state in which at least a portion of the second region forms the front surface of the electronic device together with the first region. When the electronic device is changed to the first state and the second state by the sliding of the second structure, at least a portion of the heat radiating member moves together with a portion of the second structure in a direction of the sliding.

### [Advantageous Effects]

The electronic device according to the various embodiments of the disclosure may effectively spread heat to the outside of the electronic device in the open state of the electronic device.

Furthermore, in the electronic device according to the various embodiments of the disclosure, the pressing member may be pressed in the open state and the closed state of the electronic device, and thus heat transfer between the heat radiating member and the heat generating part may be effectively performed.

In addition, the disclosure may provide various effects that are directly or indirectly recognized.

### [Description of Drawings]

FIG. 1 is a view illustrating a first state (e.g., a closed state) of an electronic device according to an embodiment.
FIG. 2 is a view illustrating a second state (e.g., an open state) of the electronic device according to an embodiment.
FIG. 3 is an exploded perspective view of the electronic device according to an embodiment.
FIG. 4 is a view illustrating a first state and a second state of an electronic device according to an embodiment.
FIG. 5 is a view illustrating movement of a heat radiating member in the first state and the second state of the electronic device according to an embodiment.
FIG. 6 is a view illustrating the heat radiating member of the electronic device according to an embodiment.
FIG. 7 is a view illustrating movement of a heat radiating member in the first state and the second state of the electronic device according to an embodiment.
FIG. 8 is a view illustrating the heat radiating member of the electronic device according to an embodiment.
FIG. 9 is a view illustrating movement of a heat radiating member in the first state and the second state of the electronic device according to an embodiment.
FIG. 10 is a view illustrating the heat radiating member of the electronic device according to an embodiment.
FIG. 11 is a view illustrating an operation between a heat radiating member and a pressing member in a process in which a state of the electronic device is changed according to an embodiment.
FIG. 12 is a view illustrating an operation between a heat radiating member and a pressing member in a process in which a state of the electronic device is changed according to an embodiment.
FIG. 13 is a block diagram of an electronic device in a network environment according to an embodiment.

With regard to description of the drawings, identical or similar reference numerals may be used to refer to identical or similar components.

### [Mode for Invention]

Hereinafter, various embodiments of the disclosure may be described with reference to accompanying drawings. Accordingly, those of ordinary skill in the art will recognize that modification, equivalent, and/or alternative on the various embodiments described herein can be variously made without departing from the scope and spirit of the disclosure.

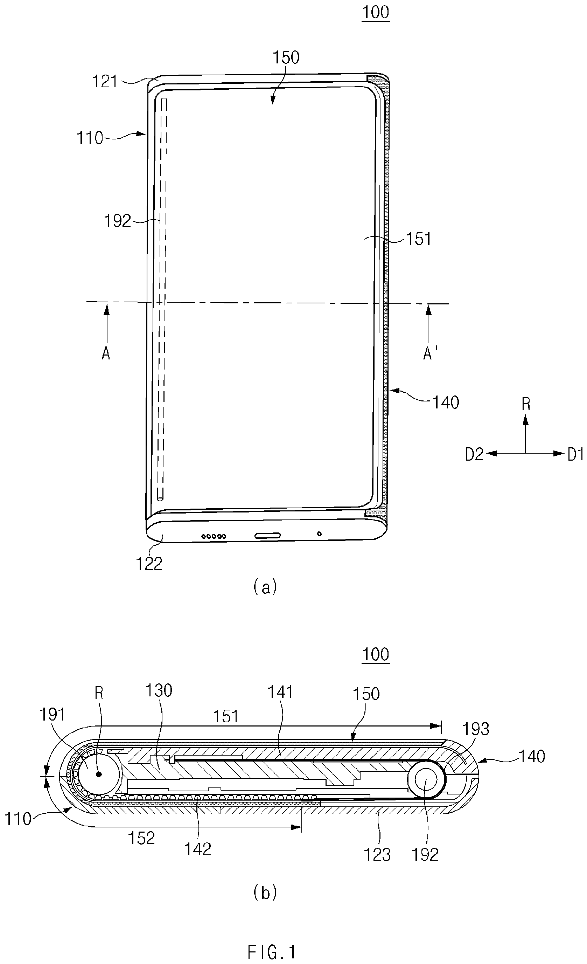

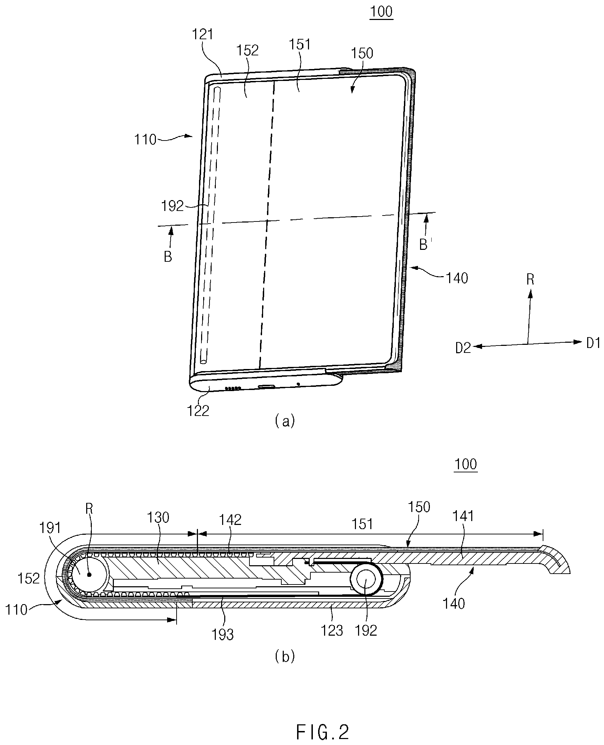

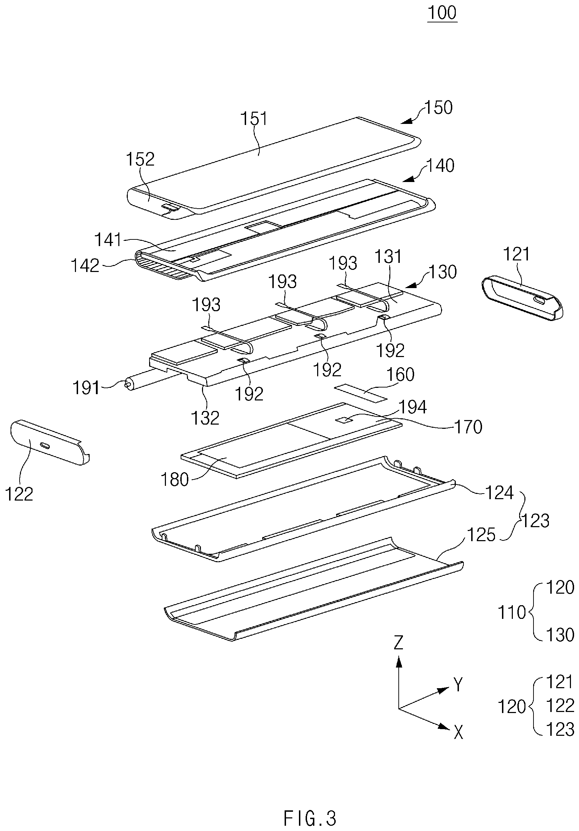

FIG. 1 is a view illustrating a first state (e.g., a closed state) of an electronic device according to an embodiment. FIG. 2 is a view illustrating a second state (e.g., an open state) of the electronic device according to an embodiment. FIG. 3 is an exploded perspective view of the electronic device according to an embodiment.

FIG. 1 (a) and (b) illustrate a perspective view and a sectional view of the electronic device, respectively, when the electronic device is in the first state. FIG. 1 (b) illustrates a sectional view of the electronic device taken along line A-A' in FIG. 1 (a). FIG. 2 (a) and (b) illustrate a perspective view and a sectional view of the electronic device, respectively, when the electronic device is in the second state. FIG. 2 (b) illustrates a sectional view of the electronic device taken along line B-B' in FIG. 2 (a).

Referring to FIGS. 1 to 3, the electronic device 100 according to an embodiment may include a first structure 110, a second structure 140, a flexible display 150, a heat radiating member 160, a circuit board 170, a battery 180, a first roller 191, a tension belt 193, and a second roller 192.

According to an embodiment, the electronic device 100 may include the first state and the second state. The first state and the second state may be determined depending on the position of the second structure 140 relative to the first structure 110, and the electronic device 100 may be changed between the first state and the second state by a user operation or a mechanical operation. For example, the second state may be a state in which the area of the flexible display 150 visually exposed through a front surface of the electronic device 100 is larger than that in the first state. The first state may be a state in which the area of the flexible display 150 exposed through the front surface of the electronic device 100 is relatively reduced, and the second state may refer to a state in which the area of the flexible display 150 exposed through the front surface of the electronic device 100 is relatively extended.

In an embodiment, the first structure 110 and the second structure 140 may be coupled to slide relative to each other. For example, the first structure 110 may be a fixed structure, and the second structure 140 may be a structure that is able to slide relative to the first structure 110. The second structure 140 may be coupled to the first structure 110 such that at least a portion of the second structure 140 slides relative to the first structure 110 in both directions (e.g., a first direction D1 and a second direction D2). For example, the electronic device 100 may be changed to the first state or the second state as the second structure 140 and the flexible display 150 slide relative to the first structure 110 in both the directions (e.g., the first direction D1 and the second direction D2).

In an embodiment, the first structure 110 may include a case 120 and a bracket 130. The bracket 130 may be coupled to the case 120 and may be at least partially surrounded by the case 120. For example, the bracket 130 may be fixed to the case 120, and the case 120 and the bracket 130 may be movable relative to the second structure 140 depending on a sliding operation of the second structure 140. The case 120 and the bracket 130 may be used as the basis for sliding movement of the second structure 140 and the flexible display 150.

In an embodiment, the case 120 may form at least a portion of an outer surface of the electronic device 100. The case 120 may include a first side member 121, a second side member 122, and a rear member 123. The first side member 121 and the second side member 122 may be disposed to face each other in a direction substantially perpendicular to sliding directions of the second structure 140 (e.g., the first direction D1 and the second direction D2). The rear member 123 may be disposed between the first side member 121 and the second side member 122 and may be connected to the first side member 121 and the second side member 122. The first side member 121, the second side member 122, and the rear member 123 may be coupled together to form a space in which at least some of the other components of the electronic device 100 (e.g., the bracket 130, the second structure 140, the heat radiating member 160, the circuit board 170, and/or the battery 180) are disposed.

In an embodiment, the rear member 123 may include a frame 124 and a cover 125. For example, the frame 124 may be coupled with the bracket 130. The cover 125 may be coupled to the frame 124 to form at least a portion of a rear surface of the electronic device 100. A space in which the second structure 140 and a second region 152 of the flexible display 150 are accommodated may be formed between the cover 125 and the bracket 130. According to an embodiment, the first side member 121, the second side member 122, the frame 124, and/or the cover 125 may be formed as separate components and may be assembled or coupled together. However, the disclosure is not limited thereto, and according to various embodiments of the disclosure, the first side member 121, the second side member 122, the frame 124, and the cover 125 may be integrally formed.

In an embodiment, the bracket 130 may be disposed to at least partially overlap the second structure 140. A first surface 131 of the bracket 130 (e.g., a surface facing in the +z-axis direction based on FIG. 3 or an upper surface) may face a plate part 141 of the second structure 140, and a second surface 132 of the bracket 130 (e.g., a surface facing in the -z-axis direction based on FIG. 3 or a lower surface) may face the circuit board 170. The circuit board 170 and the battery 180 may be disposed on the second surface 132 of the bracket 130.

In an embodiment, the second structure 140 may be disposed to surround at least a portion of the bracket 130. The second structure 140 may include the plate part 141 supporting one portion of a first region 151 of the flexible display 150 and a multi-joint part 142 supporting another portion of the first region 1151 and one portion of the second region 152 of the flexible display 150. For example, the multi-joint part 142 may extend from the plate part 141 and may be a bendable part. The multi-joint part 142 may at least partially form a curved surface in response to a sliding operation of the second structure 140.

In an embodiment, the multi-joint part 142 may be coupled to the first roller 191. The multi-joint part 142 may include a plurality of bars extending in a direction substantially parallel to a rolling axis R of the first roller 191. For example, the multi-joint part 142 may include a flexible track or a hinge rail. According to an embodiment, the plate part 141 may slide in the first direction D1 or the second direction D2. The multi-joint part 142 may be configured such that one portion is rotated by the first roller 191 and another portion slides in the first direction D 1 or the second direction D2.

In an embodiment, the first roller 191 may be disposed on one side surface of the bracket 130. The first roller 191 may be coupled so as to be rotatable relative to the bracket 130. For example, the first roller 191 may be rotatable about the rolling axis R in opposite directions depending on a sliding operation of the second structure 140. The first roller 191 may be brought into contact with a portion of the multi-joint part 142 of the second structure 140. For example, the second structure 140 may be disposed such that the multi-joint part 142 surrounds at least a portion of the first roller 191. The first roller 191 may rotate a portion of the multi-joint part 142. The first roller 191 may be brought into contact with different regions of the multi-joint part 142 depending on a change of state of the electronic device 100.

In an embodiment, the second structure 140 may be coupled to the bracket 130 by the tension belt 193 and the second roller 192 so as to slide. The tension belt 193 may connect an end portion of the plate part 141 and an end portion of the multi-joint part 142 of the second structure 140. The second roller 192 may rotate in the same direction as the first roller 191 depending on a sliding operation of the second structure 140. For example, between the plate part 141 and the multi-joint part 142, the tension belt 193 may provide tension to the multi-joint part 142. According to an embodiment, when the plate part 141 moves in the first direction D1, one end portion of the tension belt 193 connected with the plate part 141 may move in the first direction D1, and an opposite end portion of the tension belt 193 connected with the multi-joint part 142 may move in the second direction D2. In contrast, when the plate part 141 moves in the second direction D2, the one end portion of the tension belt 193 may move in the second direction D2, and the opposite end portion of the tension belt 193 may move in the first direction D1.

In an embodiment, the flexible display 150 may be disposed on the second structure 140. For example, the flexible display 150 may be coupled to the second structure 140 so as to slide relative to the first structure 110 together with the second structure 140. The flexible display 150 may include the first region 151 and the second region 152 extending from the first region 151. For example, the first region 151 may refer to a region visually exposed through the front surface of the electronic device 100 in the first state. The second region 152 may refer to a region that is located inside the electronic device 100 in the first state and that moves out of the electronic device 100 and is at least partially visually exposed through the front surface of the electronic device 100 as the electronic device 100 is changed to the second state. The electronic device 100 according to an embodiment may be configured such that in the first state, the first region 1151 forms at least a portion of the front surface of the electronic device 100 and in the second state, at least a portion of the second region 152 forms at least a portion of the front surface of the electronic device 100 together with the first region 151. For example, the second region 152 may form the front surface of the electronic device 100 together with the first region 151 as the second structure 140 moves relative to the first structure 110 in the first direction D 1. Furthermore, the second region 152 may be accommodated in the space between the bracket 130 and the rear member 123 as the second structure 140 moves relative to the first structure 110 in the second direction D2.

In an embodiment, the flexible display 150 may include a display region that is visually exposed on a surface of the electronic device 100 and on which predetermined visual information (or, a screen) is displayed. The display region may be extended or reduced as the electronic device 100 is changed between the first state and the second state. For example, in the first state, the display region may be formed by the first region 151 of the flexible display 150, and in the second state, the display region may be formed by a portion of the second region 152 of the flexible display 150 and the first region 151 thereof.

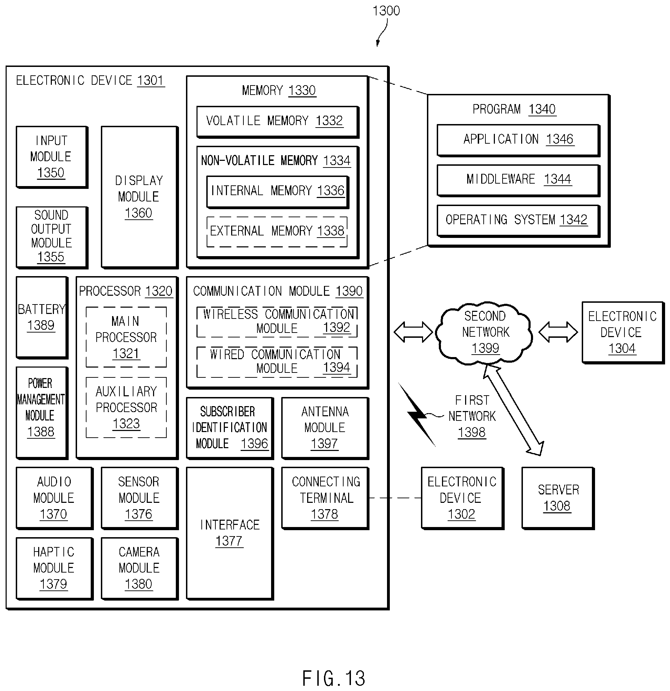

In an embodiment, the heat radiating member 160 may be disposed between the bracket 130 and the circuit board 170. The heat radiating member 160 may absorb heat generated from the circuit board 170 and may dissipate and/or spread the absorbed heat. The heat radiating member 160 may make contact with at least a portion of a heat generating part on the circuit board 170. For example, the heat radiating member 160 may make contact with a processor 194 (e.g., a processor 1320 of FIG. 13) that generates a large amount of heat. According to an embodiment, the heat radiating member 160 may remain in contact with the processor 194 in the first state and the second state. Heat generated from the processor 194 may be dissipated and/or spread to other part of the electronic device 100 through the heat radiating member 160. The heat radiating member 160 may include a material having high thermal conductivity, for example, metal or thermal conductive plastic.

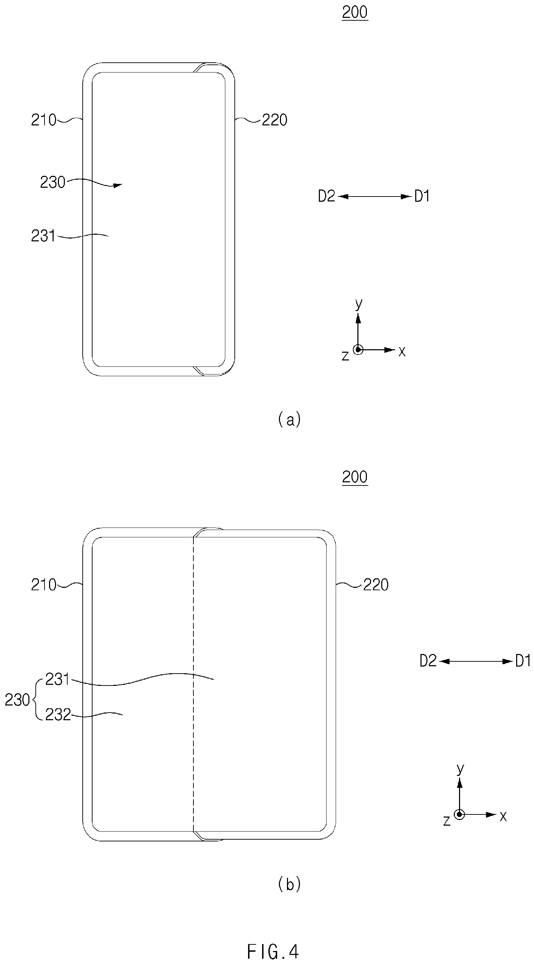

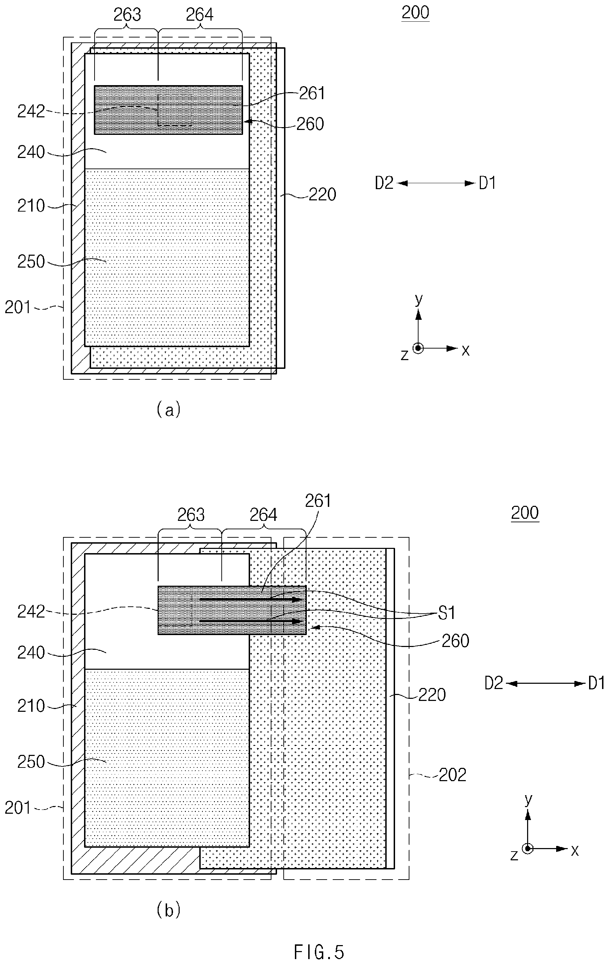

According to an embodiment, the heat radiating member 160 may move together with the second structure 140 when the second structure 140 slides. For example, at least a portion of the heat radiating member 160 may linearly move and/or rotate as the electronic device 100 is changed from the first state to the second state (e.g., refer to FIGS. 5, 7, and 9). According to various embodiments of the disclosure, at least a portion of the heat radiating member 160 may be coupled to at least a portion of the second structure 140 so as to be movable together with the second structure 140. For example, in the state of being disposed between the bracket 130 and the circuit board 170, the heat radiating member 160 may be coupled to the second structure 140 through an open region (not illustrated) that is formed in the bracket 130. Accordingly, the heat radiating member 160 may linearly move and/or rotate depending on a sliding operation of the second structure 140. Movement of the heat radiating member 160 depending on various forms of the heat radiating member 160 and states of the electronic device 100 will be described below with reference to FIGS. 4 to 10.

In an embodiment, the circuit board 170 may be disposed between the bracket 130 and the rear member 123. For example, the circuit board 170 may be supported by the bracket 130 and may be disposed inside the electronic device 100. The circuit board 170 may be coupled to at least a partial region of the second surface 132 of the bracket 130 and may be fixed to the first structure 110. For example, the circuit board 170, together with the first structure 110, may move relative to the second structure 140 when the second structure 140 slides.

In an embodiment, the circuit board 170 may include a printed circuit board (PCB), a flexible PCB (FPCB), or a rigid-flexible PCB (RFPCB). Various electronic parts included in the electronic device 100 may be electrically connected to the circuit board 170. The processor 194 (e.g., the processor 1320 of FIG. 13), a memory (e.g., a memory 1330 of FIG. 13), and/or an interface (e.g., an interface 1377 of FIG. 13) may be disposed on the circuit board 170. For example, the processor 194 may include a main processor (e.g., a main processor 1321 of FIG. 13) and/or an auxiliary processor (e.g., an auxiliary processor 1323 of FIG. 13), and the main processor and/or the auxiliary processor may include one or more of a central processing unit, an application processor, a graphic processing unit, an image signal processor, a sensor hub processor, or a communication processor. For example, the memory may include a volatile memory or a non-volatile memory. For example, the interface may include a high definition multimedia interface (HDMI), a universal serial bus (USB) interface, an SD card interface, and/or an audio interface. Furthermore, the interface may electrically or physically connect the electronic device 100 with an external electronic device and may include a USB connector, an SD card/MMC connector, or an audio connector.

In an embodiment, the battery 180 (e.g., a battery 1389 of FIG. 13) may supply power to at least one component of the electronic device 100. The battery 180 may be integrally disposed inside the electronic device 100, or may be disposed so as to be detachable from the electronic device 100. According to an embodiment, the battery 180 may be supported by the bracket 130 together with the circuit board 170 and may be disposed inside the electronic device 100. The battery 180 may be coupled to at least a partial region of the second surface 132 of the bracket 130. The battery 180 may be disposed on substantially the same plane as the circuit board 170. The battery 180, together with the first structure 110, may move relative to the second structure 140 when the second structure 140 slides.

The electronic device 100 illustrated in FIGS. 1 and 3 may be an embodiment of a slidable (or, rollable) electronic device, and the structure of the electronic device 100 according to various embodiments of the disclosure is not limited to the illustrated embodiment. For example, the electronic device 100 according to various embodiments of the disclosure may be implemented with various forms of slidable (or, rollable) electronic devices that include a fixed structure and a movable structure movable relative to the fixed structure and in which a display region is extended or reduced as a flexible display moves together with the movable structure.

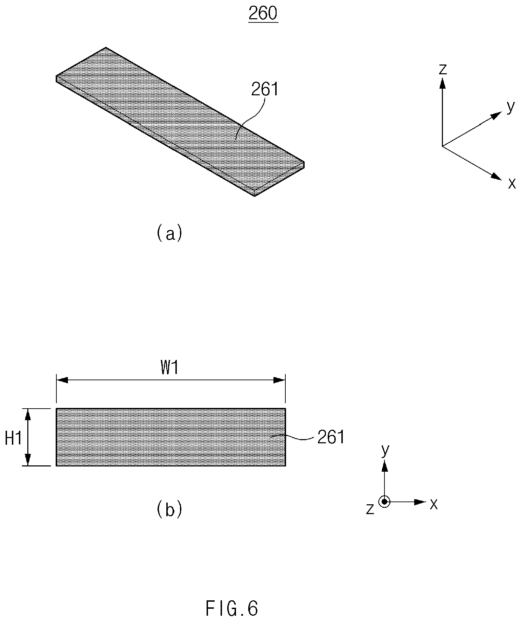

FIG. 4 is a view illustrating a first state (e.g., a closed state) and a second state (e.g., an open state) of an electronic device according to an embodiment. FIG. 5 is a view illustrating movement of a heat radiating member in the first state and the second state of the electronic device according to an embodiment. FIG. 6 is a view illustrating the heat radiating member of the electronic device according to an embodiment.

FIG. 4 (a) illustrates the first state of the electronic device, and FIG. 4 (b) illustrates the second state of the electronic device. FIG. 5 is a view for explaining the position and movement of the heat radiating member depending on the states of the electronic device. FIG. 5 (a) illustrates the position of the heat radiating member in the first state of the electronic device, and FIG. 5 (b) illustrates the position of the heat radiating member in the second state of the electronic device. FIG. 6 (a) illustrates a perspective view of the heat radiating member, and FIG. 6 (b) illustrates a plan view of the heat radiating member.

Referring to FIGS. 4 to 6, the electronic device 200 according to an embodiment (e.g., the electronic device 100 of FIGS. 1 to 3) may include a first structure 210 (e.g., the first structure 110 of FIGS. 1 to 3), a second structure 220 (e.g., the second structure 140 of FIGS. 1 to 3), a flexible display 230 (e.g., the flexible display 150 of FIGS. 1 to 3), a circuit board 240 (e.g., the circuit board 170 of FIGS. 1 to 3), a battery 250 (e.g., the battery 180 of FIGS. 1 to 3), and the heat radiating member 260 (e.g., the heat radiating member 160 of FIGS. 1 to 3). Some of the components of the electronic device 200 illustrated in FIGS. 4 to 6 may be identical or similar to some of the components of the electronic device 100 illustrated in FIGS. 1 to 3, and repetitive descriptions will hereinafter be omitted.

In an embodiment, the electronic device 200 may include the first state (e.g., FIG. 4 (a) and FIG. 5 (a)) in which a first region 231 of the flexible display 230 (e.g., the first region 151 of the flexible display 150 of FIGS. 1 to 3) forms at least a portion of a front surface (e.g., a surface facing in the +z-axis direction) of the electronic device 200 and the second state (e.g., FIG. 4 (b) and FIG. 5 (b)) in which at least a portion of a second region 232 of the flexible display 230 (e.g., the second region 152 of the flexible display 150 of FIGS. 1 to 3) forms at least a portion of the front surface of the electronic device 200 together with the first region 231. According to an embodiment, the area of the flexible display 230 visually exposed in a front direction of the electronic device 200 (e.g., the +z-axis direction) may be extended (e.g., the second state) or reduced (e.g., the first state) as the electronic device 200 is deformed in the first state and the second state.

In an embodiment, a heat generating part 242 (or, a heat generating element) that generates heat may be disposed on at least a partial region of the circuit board 240. For example, the heat generating part 242 may be a main heat source of the electronic device 200. The heat generating part 242 may include one or more parts and may generate heat while consuming electric current. For example, the heat generating part 242 may include at least one of an application processor (AP) (e.g., the processor 194 of FIG. 3 or the processor 1320 of FIG. 13) or a power management integrated circuit (PMIC) (e.g., a power management module 1388 of FIG. 13). However, the heat generating part 242 is not limited to the aforementioned parts, and according to various embodiments of the disclosure, the heat generating part 242 may further include other parts. For example, the heat generating part 242 may include a communication module (e.g., a communication module 1390 of FIG. 13) that serves to communicate with an external device.

In an embodiment, the heat radiating member 260 (e.g., a heat sink or a heat spreader) may spread and/or radiate heat generated from the heat generating part 242. For example, the heat radiating member 260 may be brought into contact with the heat generating part 242 to receive heat from the heat generating part 242 and may spread the received heat to other regions (e.g., an extended region) of the electronic device 200. The heat radiating member 260 may be formed of a metal having high heat conductivity, for example, copper (Cu), aluminum (Al), gold (Au), or silver (Ag). However, the disclosure is not limited thereto, and according to various embodiments of the disclosure, the heat radiating member 260 may be implemented using various materials capable of heat conduction.

In an embodiment, the heat radiating member 260 may be disposed on one surface (e.g., a surface facing in the +z-axis direction) of the circuit board 240. For example, the heat radiating member 260 may be disposed to be brought into contact with the heat generating part 242 disposed on the one surface of the circuit board 240. The heat radiating member 260 may remain in contact with the heat generating part 242 and may receive heat generated from the heat generating part 242. The heat radiating member 260 may include a first surface 261 that faces in the same direction (e.g., the +z-axis direction) as the one surface of the circuit board 240 and a second surface (not illustrated) that faces in the direction (e.g., the -z-axis direction) opposite to the direction of the first surface 261. The second surface may face the circuit board 240 and/or the heat generating part 242. For example, the heat generating part 242 may make contact with at least a partial region of the second surface. According to the illustrated embodiment, the heat radiating member 260 may be disposed such that at least a portion of the heat radiating member 260 overlaps the heat generating part 242 when the first surface 261 is viewed from above.

In an embodiment, the heat radiating member 260 may move together with the second structure 220 when an operational state of the electronic device 200 is changed. For example, when the electronic device 200 is changed from the first state to the second state or from the second state to the first state, the heat radiating member 260 may move together with the second structure 220 while remaining in contact with the heat generating part 242. According to an embodiment, the electronic device 200 may be changed to the second state as the second structure 220 slides relative to the first structure 210 in a first direction D1 in the first state and may be changed to the first state as the second structure 220 slides relative to the first structure 210 in a second direction D2 in the second state. In response to the sliding movement of the second structure 220, the heat radiating member 260 may move in substantially the same directions as the sliding directions of the second structure 220 (e.g., the first direction D1 and the second direction D2).

In an embodiment, when the electronic device 200 is changed from the first state to the second state (e.g., changed from FIG. 5(a) to FIG. 5 (b)), the heat radiating member 260 may linearly move in the first direction D1 relative to the circuit board 240 and the heat generating part 242 that are fixed to the first structure 210. In contrast, when the electronic device 200 is changed from the second state to the first state (e.g., changed from FIG. 5(b) to FIG. 5 (a)), the heat radiating member 260 may linearly move in the second direction D2 relative to the circuit board 240 and the heat generating part 242 that are fixed to the first structure 210. In the first state and the second state, the heat radiating member 260 may remain in contact with the heat generating part 242. For example, in the first state and the second state, the heat generating part 242 may overlap at least a portion of the heat radiating member 260 when the first surface 261 of the heat radiating member 260 is viewed from above.

In an embodiment, the heat radiating member 260 may be configured such that a region of the heat radiating member 260 in contact with the heat generating part 242 is changed as the heat radiating member 260 moves relative to the heat generating part 242. For example, in the first state and the second state, the heat generating part 242 may overlap different regions of the heat radiating member 260 when the first surface 261 (e.g., a surface facing in the +z-axis direction) of the heat radiating member 260 is viewed from above. The heat radiating member 260 may include a first contact region 264 at least partially making contact with the heat generating part 242 in the first state and a second contact region 263 at least partially making contact with the heat generating part 242 in the second state. The second contact region 263 may refer to a region extending from the first contact region 264 in the second direction D2. For example, in the first state, one portion of the first contact region 264 may make contact with the heat generating part 242. When the electronic device 200 is changed from the first state to the second state, one portion of the second contact region 263 may make contact with the heat generating part 242 in the second state as the first contact region 264 moves in the first direction D1. When the electronic device 200 is in the second state, another portion of the first contact region 264 may be disposed in an extended region 202 that extends from a default region 201 of the electronic device 200.

In an embodiment, at least a portion of the heat radiating member 260 may be located in the extended region 202 of the electronic device 200 in the second state. For example, in the second state, the electronic device 200 may form the extended region 202 that extends from the default region 201. The extended region 202 may refer to a region that extends from the default region 201 in the first direction D1 as the second structure 220 slides relative to the first structure 210 in the first direction D1 when the electronic device 200 is changed from the first state to the second state. The heat radiating member 260 may move together with the second structure 220 in the first direction D1 such that at least a portion of the heat radiating member 260 is located in the extended region 202 in the second state. For example, in the second state, the heat radiating member 260 may be located across the default region 201 and the extended region 202 in a direction (e.g., the x-axis direction) parallel to the sliding directions (e.g., the first direction D1 and the second direction D2). Since at least a portion of the heat radiating member 260 is located in the extended region 202 when the electronic device 200 is in the second state, the heat radiating member 260 may provide a heat spread path S1 along which heat generated from the heat generating part 242 is spread to the extended region 202. For example, in the second state, heat generated from the heat generating part 242 may be spread (e.g., the heat spread path S1) from the default region 201 toward the extended region 202 through the heat radiating member 260.

In an embodiment, the heat radiating member 260 may be coupled to at least a portion of the second structure 220 to linearly move together with the second structure 220 in the first direction D1 and the second direction D2. For example, the heat radiating member 260 may be fixed and/or fastened to at least a portion of the second structure 220 so as to be movable relative to the first structure 210 and the circuit board 240. The heat radiating member 260 may be allowed to move in the first direction D1 and the second direction D2, but may be restricted from moving in another direction perpendicular to the first direction D1 or the second direction D2. For example, at least a portion of the heat radiating member 260 may be constrained to another component (e.g., the first structure 210 or the circuit board 240) of the electronic device 200 such that the heat radiating member 260 is movable in the x-axis direction depending on movement of the second structure 220, but is restricted from moving in the y-axis direction and/or the z-axis direction. A structure for coupling and/or fastening the heat radiating member 260 is not limited to a specific method. According to various embodiments of the disclosure, the heat radiating member 260 may be coupled to some components of the electronic device 200 so as to be movable in the first direction D1 and the second direction D2 depending on a sliding operation of the second structure 220.

In an embodiment, the heat radiating member 260 may be formed in a plate shape having a specified width (e.g., a length in the x-axis direction) and a specified height (e.g., a length in the y-axis direction). The heat radiating member 260 may be formed in such a size that the heat radiating member 260 is able to continue to make contact with(or, overlap) the heat generating part 242 depending on an operational state of the electronic device 200. For example, the heat radiating member 260 may have a height H1 that is greater than the height (e.g., the length in the y-axis direction) of the heat generating part 242 or substantially the same as the height of the heat generating part 242. In addition, the heat radiating member 260 may have a width W1 by which when the electronic device 200 is in the second state, one portion of the heat radiating member 260 (e.g., one portion of the second contact region 263) continues to overlap the heat generating part 242 and another portion of the heat radiating member 260 (e.g., one portion of the first contact region 264) is disposed in the extended region 202 of the electronic device 200.

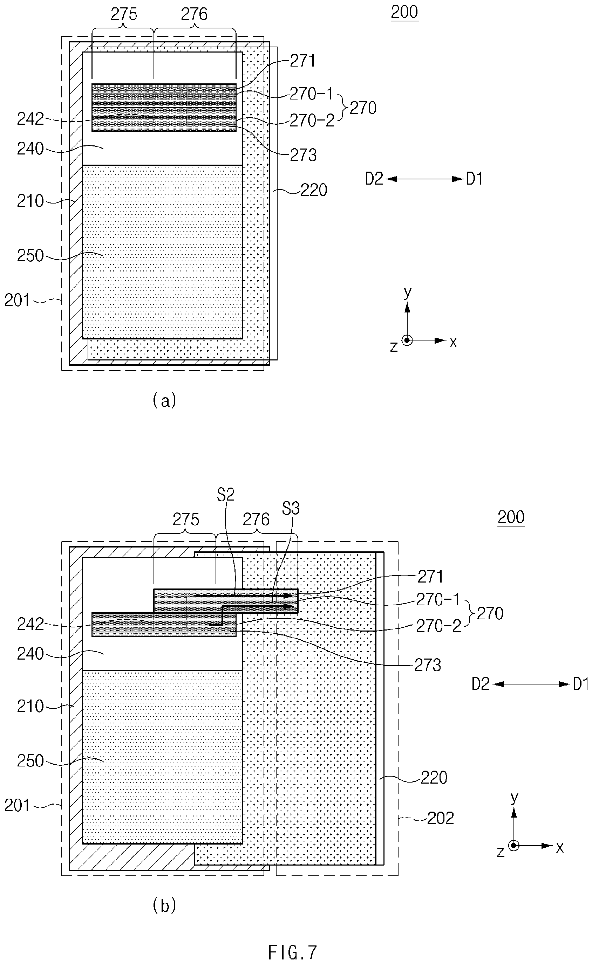

According to the embodiment illustrated in FIG. 6, the heat radiating member 260 may have a rectangular shape in which the width W1 is greater than the height H1. However, the shape of the heat radiating member 260 is not limited to the illustrated embodiment, and the heat radiating member 260 may be formed in various sizes and shapes. The shape of the heat radiating member 260 according to various embodiments of the disclosure will be described below with reference to FIGS. 7 to 10.

According to various embodiments of the disclosure, at least a portion of the heat radiating member 260 may be movable depending on a sliding operation of the second structure 220 relative to the first structure 210 and may be disposed in the extended region 202 of the electronic device 200 in the second state in which the electronic device 200 is extended. Accordingly, when the electronic device 200 is in the second state, heat may be transferred to the extended region 202 through the heat radiating member 260, and thus the heat dissipation performance of the electronic device 200 may be improved.

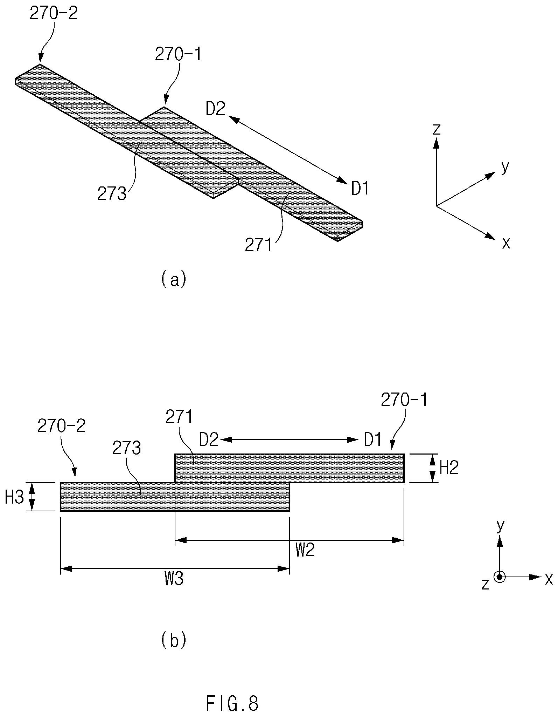

FIG. 7 is a view illustrating movement of a heat radiating member in the first state and the second state of the electronic device according to an embodiment. FIG. 8 is a view illustrating the heat radiating member of the electronic device according to an embodiment.

FIG. 7 (a) illustrates the position of the heat radiating member when the electronic device is in the first state, and FIG. 7 (b) illustrates the position of the heat radiating member when the electronic device is in the second state. FIG. 8 (a) illustrates a perspective view of the heat radiating member, and FIG. 8 (b) illustrates a plan view of the heat radiating member.

Referring to FIGS. 7 and 8, the electronic device 200 according to an embodiment (e.g., the electronic device 100 of FIGS. 1 to 3) may include the first structure 210 (e.g., the first structure 110 of FIGS. 1 to 3), the second structure 220 (e.g., the second structure 140 of FIGS. 1 to 3), the circuit board 240 (e.g., the circuit board 170 of FIGS. 1 to 3), the battery 250 (e.g., the battery 180 of FIGS. 1 to 3), and the heat radiating member 270 (e.g., the heat radiating member 160 of FIGS. 1 to 3).

FIGS. 7 and 8 illustrate an embodiment in which the shape and/or structure of the heat radiating member (e.g., the heat radiating member 260 of FIGS. 5 and 6) in the electronic device 200 is changed. Therefore, repetitive descriptions will hereinafter be omitted, and the following description will be focused on the difference.

In an embodiment, the heat radiating member 270 may include a first plate 270-1 and a second plate 270-2 that move relative to each other in response to a sliding operation of the second structure 220. Although the heat radiating member according to the embodiment illustrated in FIGS. 5 and 6 (e.g., the heat radiating member 260 of FIGS. 5 and 6) is constituted by one piece, the heat radiating member 270 according to the embodiment illustrated in FIGS. 7 and 8 may be constituted by two pieces. For example, although the heat radiating member 260 of FIGS. 5 and 6 is formed of one plate, the heat radiating member 270 of FIGS. 7 and 8 may be formed of two separate plates, and the two plates may be movable relative to each other.

In an embodiment, the first plate 270-1 and the second plate 270-2 may be disposed on one surface (e.g., a surface facing in the +z-axis direction) of the circuit board 240. For example, at least a portion of the first plate 270-1 and at least a portion of the second plate 270-2 may be disposed to make contact with the heat generating part 242 disposed on the one surface of the circuit board 240. The first plate 270-1 and the second plate4 270-2 may be disposed to face each other in a direction perpendicular to the sliding directions D1 and D2. For example, the first plate 270-1 and the second plate4 270-2 may face each other in the y-axis direction. The first plate 270-1 and the second plate4 270-2 may be brought into contact with each other. For example, the first plate 270-1 may move relative to the second plate 270-2 in the sliding directions D1 and D2 while maintaining the contact with the second plate 270-2. Since the first plate 270-1 and the second plate 270-2 remain in contact with each other, heat may be transferred between the first plate 270-1 and the second plate 270-2.

In an embodiment, the first plate 270-1 and the second plate 270-2 may form substantially the same plane. For example, the first plate 270-1 may include a third surface 271 that faces in the same direction (e.g., the +z-axis direction) as the one surface of the circuit board 240 and a fourth surface (not illustrated) that faces in the direction (e.g., the -z-axis direction) opposite to the direction of the third surface 271. The second plate 270-2 may include a fifth surface 273 that faces in the same direction as the third surface 271 and a sixth surface (not illustrated) that faces away from the fifth surface 273. The third surface 271 and the fifth surface 273 may form substantially the same plane, and the fourth surface and the sixth surface may form substantially the same plane. The fourth surface of the first plate 270-1 and the sixth surface of the second plate 270-2 may face the circuit board 240 and/or the heat generating part 242. For example, the heat generating part 242 may make contact with at least partial regions of the fourth surface and the sixth surface. According to the illustrated embodiment, the first plate 270-1 and the second plate 270-2 may be disposed such that the heat generating part 242 overlaps at least a portion of the first plate 270-1 and at least a portion of the second plate 270-2 when the third surface 271 or the fifth surface 273 is viewed from above.

In an embodiment, a part (e.g., the first plate 270-1) of the heat radiating member 270 may move together with the second structure 220 when an operational state of the electronic device 200 is changed. For example, when the electronic device 200 is changed from the first state to the second state or from the second state to the first state, the first plate 270-1 of the heat radiating member 270 may move together with the second structure 220 while remaining in contact with the heat generating part 242. The second plate 270-2 of the heat radiating member 270 may be relatively fixed with respect to the movement of the first plate 270-1. For example, the second plate 270-2 may be fixed to the first structure 210 and/or the circuit board 240, and the first plate 270-1 may move relative to the second plate 270-2 in the sliding directions (e.g., the first direction D1 and the second direction D2) as the second structure 220 slides relative to the first structure 210.

In an embodiment, when the electronic device 200 is changed from the first state to the second state (e.g., changed from FIG. 7 (a) to FIG. 7 (b)), the first plate 270-1 may linearly move relative to the second plate 270-2, the circuit board 240, and the heat generating part 242 in the first direction D1 . In contrast, when the electronic device 200 is changed from the second state to the first state (e.g., changed from FIG. 7 (b) to FIG. 7 (a)), the first plate 270-1 may linearly move relative to the second plate 270-2, the circuit board 240, and the heat generating part 242 in the second direction D2. In the first state and the second state, the first plate 270-1 and the second plate 280-2 may remain in contact with the heat generating part 242. For example, as the first plate 270-1 moves together with the second structure 220, different regions of the first plate 270-1 may be brought into contact with the heat generating part 242 in the first state and the second state. Since the second plate 270-2 is fixed to the first structure 210 or the circuit board 240 so as to be separated from the movement of the second structure 220 and the first plate 270-1, a region of the second plate 270-2 in contact with the heat generating part 242 may be identically maintained in the first state and the second state without being changed.

In an embodiment, the first plate 270-1 may include a first contact region 276 at least partially making contact with the heat generating part 242 in the first state and a second contact region 275 at least partially making contact with the heat generating part 242 in the second state. The second contact region 275 may refer to a region extending from the first contact region 276 in the second direction D2. For example, in the first state, a portion of the first contact region 276 may make contact with the heat generating part 242. When the electronic device 200 is changed from the first state to the second state, one portion of the second contact region 275 may make contact with the heat generating part 242 in the second state as the first contact region 276 moves in the first direction D 1.

In an embodiment, when the electronic device 200 is in the second state, at least a portion of the first plate 270-1 may be disposed in the extended region 202. For example, the first plate 270-1 may move together with the second structure 220 in the first direction D1 such that at least a portion of the first plate 270-1 is located in the extended region 202 in the second state. When the electronic device 200 is in the second state, at least a portion of the first plate 270-1 may be located in the extended region 202 while the first plate 270-1 and the second plate 270-2 remain in contact with each other. Accordingly, the heat radiating member 270 may provide heat spread paths S2 and S3 along which heat generated from the heat generating part 242 is spread to the extended region 202. For example, in the second state, heat generated from the heat generating part 242 may be directly spread to the extended region 202 through the first plate 270-1 (e.g., the first heat spread path S2), or may be spread to the extended region 202 through the second plate 270-2 and the first plate 270-1 (e.g., the second heat spread path S3).

In an embodiment, the first plate 270-1 may be coupled to at least a portion of the second structure 220 so as to be linearly movable together with the second structure 220 in the first direction D1 and the second direction D2. The second plate 270-2 may be coupled to at least a portion of the first structure 210 and/or the circuit board 240 so as to be separated from movement of the second structure 220. The first plate 270-1 may be allowed to move in the first direction D1 and the second direction D2, but may be restricted from moving in another direction perpendicular to the first direction D1 or the second direction D2. For example, at least a portion of the first plate 270-1 may be constrained to another component (e.g., the first structure 210 or the circuit board 240) of the electronic device 200 such that the first plate 270-1 is movable in the x-axis direction depending on movement of the second structure 220, but is restricted from moving in the y-axis direction and/or the z-axis direction. In addition, the second plate 270-2 may be constrained to some components (e.g., the first structure 210 or the circuit board 240) of the electronic device 200 such that movement of the second plate 270-2 in the x-axis direction, the y-axis direction, and the z-axis direction is restricted when the second structure 220 slides.

In an embodiment, each of the first plate 270-1 and the second plate 270-2 may be formed in a plate shape having a specified width (e.g., a length in the x-axis direction) and a specified height (e.g., a length in the y-axis direction). For example, the sum of the height H2 of the first plate 270-1 and the height H3 of the second plate 270-2 may be greater than the height (e.g., the length in the y-axis direction) of the heat generating part 242, or may be substantially the same as the height of the heat generating part 242. According to the illustrated embodiment, the first plate 270-1 and the second plate 270-2 may have substantially the same shape. For example, the width W2 and the height H2 of the first plate 270-1 may be substantially the same as the width W3 and the height H3 of the second plate 270-2. However, the shapes of the first plate 270-1 and the second plate 270-2 are not limited to the illustrated embodiment, and according to various embodiments of the disclosure, the first plate 270-1 and the second plate 270-2 may have different shapes. For example, the width W3 of the second plate 270-2 may be smaller than the width W2 of the first plate 270-1. Furthermore, the height H2 of the first plate 270-1 may be greater than the height H3 of the second plate 270-2. In contrast, the height H2 of the first plate 270-1 may be smaller than the height H3 of the second plate 270-2.

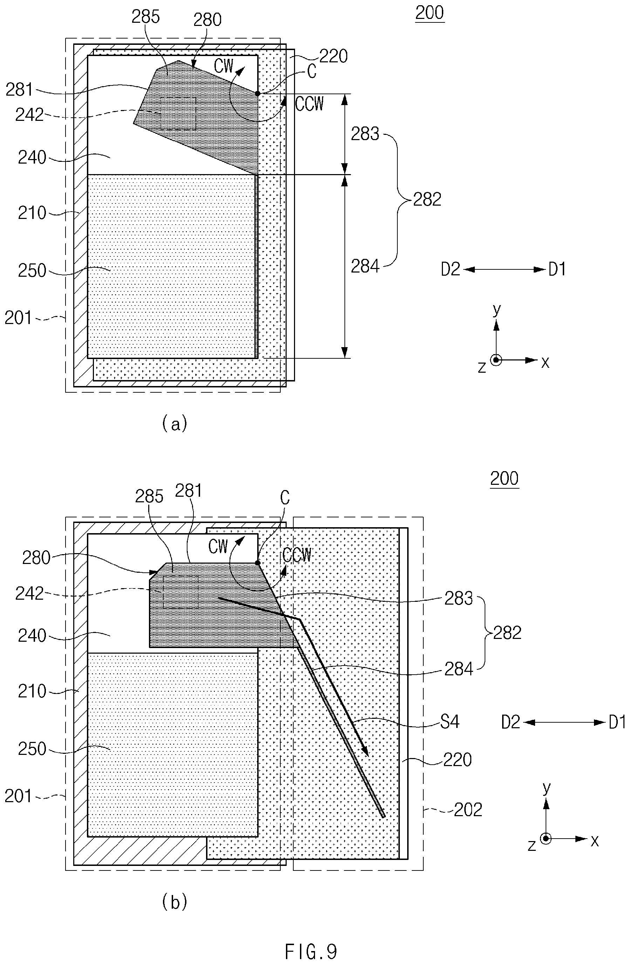

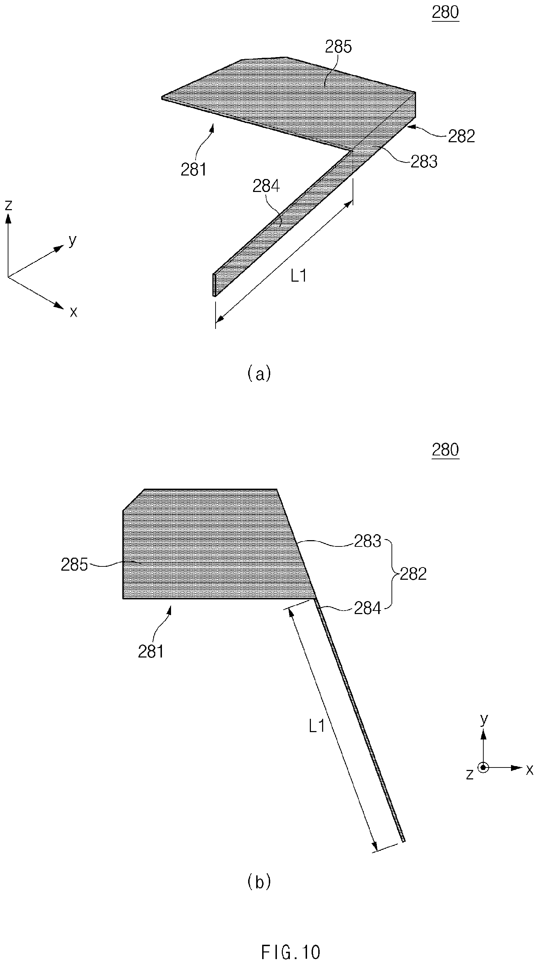

FIG. 9 is a view illustrating movement of a heat radiating member in the first state and the second state of the electronic device according to an embodiment. FIG. 10 is a view illustrating the heat radiating member of the electronic device according to an embodiment.

FIG. 9 (a) illustrates the position of the heat radiating member when the electronic device is in the first state, and FIG. 9 (b) illustrates the position of the heat radiating member when the electronic device is in the second state. FIG. 10 (a) illustrates a perspective view of the heat radiating member, and FIG. 10 (b) illustrates a plan view of the heat radiating member.

Referring to FIGS. 9 and 10, the electronic device 200 according to an embodiment (e.g., the electronic device 100 of FIGS. 1 to 3) may include the first structure 210 (e.g., the first structure 110 of FIGS. 1 to 3), the second structure 220 (e.g., the second structure 140 of FIGS. 1 to 3), the circuit board 240 (e.g., the circuit board 170 of FIGS. 1 to 3), the battery 250 (e.g., the battery 180 of FIGS. 1 to 3), and the heat radiating member 280 (e.g., the heat radiating member 160 of FIGS. 1 to 3).

FIGS. 9 and 10 illustrate an embodiment in which the shape and/or structure of the heat radiating member (e.g., the heat radiating member 260 of FIGS. 5 and 6 or the heat radiating member 270 of FIGS. 7 and 8) in the electronic device 200 is changed. Therefore, repetitive descriptions will hereinafter be omitted, and the following description will be focused on the difference.

In an embodiment, the heat radiating member 280 may rotate relative to the circuit board 240 or the heat generating part 242 in response to a sliding operation of the second structure 220. The heat radiating members according to the embodiments illustrated in FIGS. 5 to 8 (e.g., the heat radiating member 260 of FIGS. 5 and 6 or the heat radiating member 270 of FIGS. 7 and 8) may be configured such that all (e.g., the heat radiating member 260 of FIGS. 5 and 6) or at least part (e.g., the first plate 270-1 of the heat radiating member 270 of FIGS. 7 and 8) of the heat radiating member linearly moves in the same direction as the sliding directions of the second structure 220 (e.g., the first direction D1 and the second direction D2) as the second structure 220 slides. In contrast, the heat radiating member 280 according to the embodiment illustrated in FIGS. 9 and 10 may rotate in both directions (e.g., the clockwise direction CW and the counterclockwise direction CCW) within a specified range as the second structure 220 slides.

In an embodiment, the heat radiating member 280 may include a first part 281, at least a portion of which makes contact with the heat generating part 242, and a second part 282 that is perpendicular to the first part 281 and that extends to a predetermined length. The second part 282 may include a first extending portion 283 that extends from an edge of the first part 281 in a vertical direction (e.g., the -z-axis direction) and a second extending portion 284 that extends in the lengthwise direction of the electronic device 200 to form the same plane as the first extending portion 283. In the electronic device 200 according to an embodiment, the second part 282 may be formed to be perpendicular to the first part 281, and thus a space required for mounting the heat radiating member 280 in the electronic device 200 may be reduced.

In an embodiment, the first part 281 may be disposed on one surface (e.g., a surface facing in the +z-axis direction) of the circuit board 240. Since the first part 281 is disposed on the one surface of the circuit board 240, the second part 282 may be disposed to face side surfaces (e.g., surfaces facing in the +x-axis direction) of the circuit board 240 and the battery 250. For example, at least a portion of the first part 281 may be disposed to make contact with the heat generating part 242 disposed on the one surface of the circuit board 240. The first part 281 may include a seventh surface 285 that faces in the same direction (e.g., the +z-axis direction) as the one surface of the circuit board 240 and an eighth surface (not illustrated) that faces in the direction (e.g., the -z-axis direction) opposite to the direction of the seventh surface 285. The eighth surface of the first part 281 may face the circuit board 240 and/or the heat generating part 242. For example, the heat generating part 242 may make contact with at least a partial region of the eighth surface. According to the illustrated embodiment, the heat radiating member 280 may be disposed such that at least a portion of the first part 281 overlaps the heat generating part 242 when the seventh surface 285 is viewed from above.

In an embodiment, the heat radiating member 280 may move together with the second structure 220 when an operational state of the electronic device 200 is changed. For example, when the electronic device 200 is changed from the first state to the second state or from the second state to the first state, the heat radiating member 280 may move together with the second structure 220 while remaining in contact with at least a portion of the first part 281 and the heat generating part 242. According to an embodiment, the heat radiating member 280 may rotate relative to the circuit board 240 or the heat generating part 242 in response to a sliding operation of the second structure 220. For example, the heat radiating member 280 may rotate about a virtual central axis of rotation C within a specified range by the sliding operation of the second structure 220. The heat radiating member 280 may rotate about the virtual central axis of rotation C relative to the circuit board 240, the heat generating part 242, and/or the battery 250. The virtual central axis of rotation C may be defined as a virtual axis that penetrates the circuit board 240 and at least a portion of the first part 281 in the vertical direction (e.g., the z-axis direction).

In an embodiment, when the electronic device 200 is changed from the first state to the second state (e.g., changed from FIG. 9(a) to FIG. 9 (b)), the heat radiating member 280 may rotate in the counterclockwise direction CCW relative to the circuit board 240 and the heat generating part 242 that are fixed to the first structure 210. In contrast, when the electronic device 200 is changed from the second state to the first state (e.g., changed from FIG. 9(b) to FIG. 9 (a)), the heat radiating member 280 may rotate in the clockwise direction CW relative to the circuit board 240 and the heat generating part 242 that are fixed to the first structure 210. In the first state and the second state, the heat radiating member 280 may remain in contact with the heat generating part 242. For example, in the first state and the second state, the first part 281 may continue to overlap the heat generating part 242 when the seventh surface 285 is viewed from above.

In an embodiment, when the electronic device 200 is in the second state, at least a portion of the heat radiating member 280 may be disposed in the extended region 202. For example, the heat radiating member 280 may rotate about the virtual central axis of rotation C in the counterclockwise direction CCW as the second structure 220 moves in the first direction D1. At least a portion of the heat radiating member 280 may be located in the extended region 202 in the second state as the heat radiating member 280 rotates in the counterclockwise direction CCW. For example, in the second state, at least a portion of the second part 282 may be located to be spaced apart from the side surfaces (e.g., the surfaces facing in the +x-axis direction) of the circuit board 240 and the battery 250 in the first direction D1. Since at least a portion of the heat radiating member 280 is located in the extended region 202 when the electronic device 200 is in the second state, the heat radiating member 280 may provide a heat spread path S4 along which heat generated from the heat generating part 242 is spread to the extended region 202. For example, in the second state, heat generated from the heat generating part 242 may be transferred to the first extending portion 283 or the second extending portion 284 of the second part 282 through the first part 281 and thus may be spread to the extended region 202 (e.g., the heat spread path S4).

In an embodiment, the heat radiating member 280 may be coupled to at least a portion of the second structure 220 so as to be rotatable in both the directions (e.g., the counterclockwise direction CCW and the clockwise direction CW) by a sliding operation of the second structure 220 in both directions (e.g., the first direction D1 and the second direction D2). For example, the heat radiating member 280 may be rotatable in the clockwise direction CW and the counterclockwise direction CCW depending on movement of the second structure 220, but may be restricted from linearly moving in another direction. For example, since the heat radiating member 280 is rotated by the movement of the second structure 220, at least a portion of the heat radiating member 280 may be constrained to another component (e.g., the first structure 210 or the circuit board 240) of the electronic device 200 such that the heat radiating member 280 is at least partially movable in the x-axis direction and/or the y-axis direction, but is restricted from moving in the z-axis direction.

In an embodiment, the heat radiating member 280 may be formed such that the second extending portion 284 of the second part 282 extends by a specified length L1. The second extending portion 284 may extend by a length by which at least part of the second extending portion 284 is disposed in the extended region 202 in the second state. For example, when the length L1 of the second extending portion 284 is long, the area of the second extending portion 284 disposed in the extended region 202 in the second state may be increased, and thus heat may be effectively spread. According to the illustrated embodiment, the second extending portion 284 may extend such that in the first state, an end of the second extending portion 284 is located on substantially the same line as an end of the battery 250. However, the disclosure is not necessarily limited to the illustrated embodiment, and according to various embodiments of the disclosure, the length L1 of the second extending portion 284 may be changed.

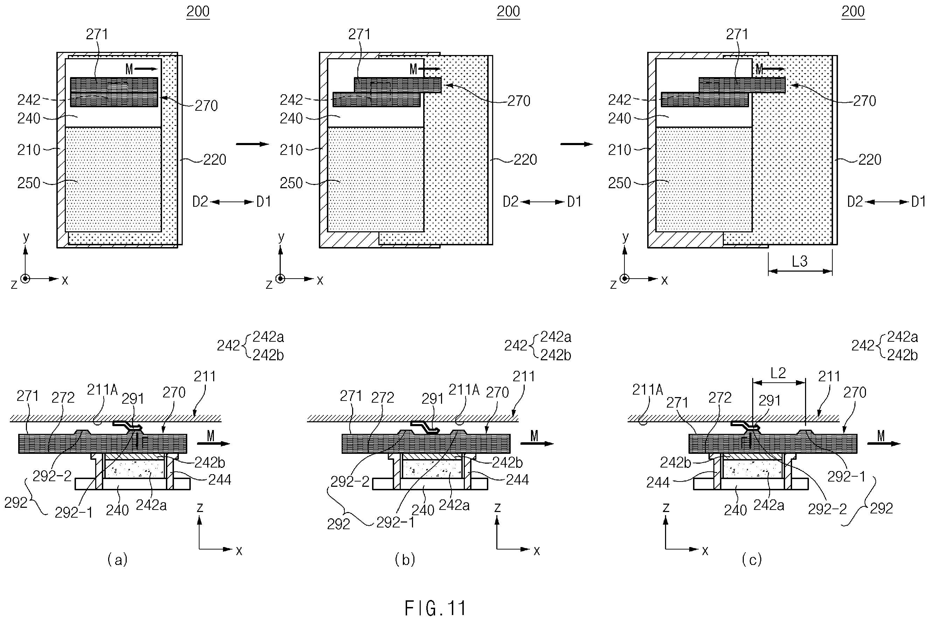

FIG. 11 is a view illustrating an operation between a heat radiating member and a pressing member in a process in which a state of the electronic device is changed according to an embodiment.

FIG. 11 (a) illustrates the heat radiating member and the pressing member when the electronic device is in the first state, FIG. 11 (b) illustrates the heat radiating member and the pressing member when the electronic device is in an intermediate state between the first state and the second state, and FIG. 11 (c) illustrates the heat radiating member and the pressing member when the electronic device is in the second state.

Referring to FIG. 11, the electronic device 200 according to an embodiment (e.g., the electronic device 100 of FIGS. 1 to 3) may include the first structure 210 (e.g., the first structure 110 of FIGS. 1 to 3), the second structure 220 (e.g., the second structure 140 of FIGS. 1 to 3), the circuit board 240 (e.g., the circuit board 170 of FIGS. 1 to 3), the battery 250 (e.g., the battery 180 of FIGS. 1 to 3), and the heat radiating member 270 (e.g., the heat radiating member 160 of FIGS. 1 to 3).

According to the embodiment illustrated in FIG. 11, the electronic device 200 may include the heat radiating member 270 illustrated in FIGS. 7 and 8. However, this is illustrative, and according to various embodiments of the disclosure, the heat radiating member 270 may be replaced with the heat radiating member 260 illustrated in FIGS. 5 and 6. For example, FIG. 11 is a view for explaining a pressing structure of the heat radiating member (e.g., the heat radiating member 260 of FIGS. 5 and 6 or the heat radiating member 270 of FIGS. 7 and 8) that linearly moves together with the second structure 220, and the pressing structure illustrated in FIG. 11 may be identically applied to the heat radiating member 260 of FIGS. 5 and 6.

In an embodiment, the first structure 210 may include a bracket 211 (e.g., the bracket 130 of FIGS. 1 to 3) disposed in the electronic device 200 to face the circuit board 240. The pressing member 291 capable of elastic deformation may be disposed on one surface of the bracket 211. For example, a second surface 211A of the bracket 211 (e.g., the second surface 132 of the bracket 130 of FIG. 3) may face the circuit board 240 and the heat radiating member 270, and the pressing member 291 may be disposed on the second surface 211A of the bracket 211 so as to be located between the bracket 211 and the heat radiating member 270. The pressing member 291 may be disposed between the second surface 211A of the bracket 211 and the heat radiating member 270. The pressing member 291 may press the heat radiating member 270 in the first state and the second state. The pressing member 291 may be compressed or uncompressed depending on whether an opposite end portion of the pressing member 291 makes contact with a protrusion 291 in a state in which one end portion of the pressing member 291 is supported on the second surface 211A of the bracket 211.

In an embodiment, the circuit board 240 may be fixed to the first structure 210 so as to be movable relative to the second structure 220 and the heat radiating member 270. The heat generating part 242 (e.g., the processor 194 of FIG. 3) and a support member 244 may be disposed on the circuit board 240.

In an embodiment, the heat generating part 242 may be disposed on one surface (e.g., a surface facing in the +z-axis direction) of the circuit board 240. The heat generating part 242 may include a circuit element 242a (e.g., the processor 1320 of FIG. 13) that substantially generates heat and a thermally conductive sheet 242b disposed on one surface of the circuit element 242a. For example, the circuit element 242a may include an IC chip, a chipset, or an application processor (AP). The thermally conductive sheet 242b may be disposed between the circuit element 242a and the heat radiating member 270. The thermally conductive sheet 242b may receive heat generated from the circuit element 242a. For example, both surfaces of the thermally conductive sheet 242b may make contact with the circuit element 242a and the heat radiating member 270, respectively, such that heat is conducted between the circuit element 242a and the heat radiating member 270. According to various embodiments of the disclosure, the thermally conductive sheet 242b may include a thermal interface material (TIM). For example, the thermally conductive sheet 242b may be provided in the form of an adhesive, grease, gel, liquid, or a pad.

According to various embodiments of the disclosure, the thermally conductive sheet 242b between the circuit element 242a and the heat radiating member 270 may cover the circuit element 242a and may provide a function of preventing damage to the circuit element 242a when the heat radiating member 270 moves relative to the circuit element 242a.

According to the illustrated embodiment, the heat generating part 242 may include the circuit element 242a and the thermally conductive sheet 242b disposed to cover one surface of the circuit element 242a, and when the heat radiating member 270 makes contact with the heat generating part 242, the circuit element 242a may make indirect contact with the heat radiating member 270 through the thermally conductive sheet 242b. However, the heat generating part 242 is not limited to the illustrated embodiment. According to various embodiments of the disclosure, the heat generating part 242 may not include the thermally conductive sheet 242b. Accordingly, when the heat radiating member 270 makes contact with the heat generating part 242, the circuit element 242a, which substantially generates heat, may make direct contact with the heat radiating member 270. In addition, according to various embodiments of the disclosure, the electronic device 200 may further include a heat conduction member (not illustrated) that is additionally disposed between the heat generating part 242 and the heat radiating member 270. For example, the additional heat conduction member (not illustrated) may be disposed between the thermally conductive sheet 242b and the heat radiating member 270 and may include a thermal interface material (TIM).

In an embodiment, the support member 244 may be disposed on the circuit board 240 to surround at least a portion of the heat generating part 242 (e.g., the circuit element 242a and the thermally conductive sheet 242b). The support member 244 may be brought into contact with the heat radiating member 270 and may support the heat radiating member 270. For example, the support member 244 may include a shield-can.

In an embodiment, the heat radiating member 270 may be disposed between the circuit board 240 and the bracket 211. The heat radiating member 270 may move relative to the bracket 211 and the circuit board 240 as the second structure 220 slides relative to the first structure 210. According to the illustrated embodiment, the heat radiating member 270 may be configured such that at least a portion of the heat radiating member 270 (e.g., the first plate 270-1 of the heat radiating member 270 of FIGS. 7 and 8) linearly moves relative to the bracket 211 and the circuit board 240 in the first direction D1 and the second direction D2. The direction in which the heat radiating member 270 moves may be substantially the same as the direction of movement of the second structure 220.

In an embodiment, the heat radiating member 270 may include at least one protrusion 292 extending toward the second surface 211A of the bracket 211 (e.g., the second surface 132 of the bracket 130 of FIG. 3). For example, the heat radiating member 270 may include a first surface 271 (e.g., a surface facing in the +z-axis direction) that faces the bracket 211 and a second surface 272 (e.g., a surface facing in the -z-axis direction) that faces away from the first surface 271. The protrusion 292 may protrude to a specified height from the first surface 271 of the heat radiating member 270 toward the bracket 211. The protrusion 292 may include a first protrusion 292-1 making contact with the pressing member 291 in the first state and a second protrusion 292-2 making contact with the pressing member 291 in the second state.

In an embodiment, the pressing member 291 may press the heat radiating member 270 toward the circuit board 240 (e.g., in the -z-axis direction) in the first state (e.g., FIG. 11 (a)) and the second state (e.g., FIG. 11 (c)). Furthermore, the pressing member 291 may be configured so as not to press the heat radiating member 270 in any intermediate state (e.g., FIG. 11 (b)) between the first state and the second state. The distance L2 between the first protrusion 292-1 and the second protrusion 292-2 may be substantially the same as the distance L3 by which the second structure 220 slides relative to the first structure 210. Accordingly, the pressing member 291 may make contact with the first protrusion 292-1 in the first state and may make contact with the second protrusion 292-2 in the second state.

As illustrated in FIG. 11 (a), in the first state, the pressing member 291 may be compressed toward the bracket 211 (e.g., in the +z-axis direction) by making contact with the first protrusion 292-1. The pressing member 291 in the compressed state may generate an elastic force F toward the heat radiating member 270 (e.g., in the -z-axis direction), and the heat radiating member 270 may be pressed toward the circuit board 240 by the elastic force F. Accordingly, in the first state, the heat radiating member 270 may remain brought into close contact with the heat generating part 242 (or, the thermally conductive sheet 242b).

As illustrated in FIG. 11 (b), in the intermediate state between the first state and the second state, the pressing member 291 may be disposed between the first protrusion 292-1 and the second protrusion 292-2. For example, the pressing member 291 may be located between the first protrusion 292-1 and the second protrusion 292-2 as the heat radiating member 270 moves (M) relative to the bracket 211 in the first direction D1 when the electronic device 200 is changed from the first state to the second state. The pressing member 291 may not make contact with the first protrusion 292-1 and the second protrusion 292-2 and thus may be uncompressed. Since the electronic device 200 is configured such that the pressing member 291 does not press the heat radiating member 270 in the intermediate state, movement of the heat radiating member 270 may not be obstructed by friction between the pressing member 291 and the heat radiating member 270 when the electronic device 200 is changed between the first state and the second state.

As illustrated in FIG. 11 (c), in the second state, the pressing member 291 may be compressed toward the bracket 211 (e.g., in the +z-axis direction) by making contact with the second protrusion 292-2. For example, as the heat radiating member 270 continues to move (M) relative to the bracket 211 in the first direction D1 in the intermediate state (e.g., FIG. 11 (b)), the pressing member 291 may make contact with the second protrusion 292-2 while being compressed toward the bracket 211. The pressing member 291 in the compressed state may generate an elastic force F toward the heat radiating member 270 (e.g., in the -z-axis direction), and the heat radiating member 270 may be pressed toward the circuit board 240 by the elastic force F. Accordingly, in the second state, the heat radiating member 270 may remain brought into close contact with the heat generating part 242 (or, the thermally conductive sheet 242b).

In an embodiment, when the electronic device 200 is changed from the first state to the second state (e.g., changed in the order of FIG. 11 (a), (b), and (c)), the heat radiating member 270 may move (M) relative to the bracket 211 in the first direction D1, and the pressing member 291 may be sequentially disposed on the first protrusion 292-1, between the first protrusion 292-1 and the second protrusion 292-2, and on the second protrusion 292-2. In contrast, when the electronic device 200 is changed from the second state to the first state (e.g., changed in the order of FIG. 11 (c), (b), and (a)), the heat radiating member 270 may move relative to the bracket 211 in the second direction D2, and the pressing member 291 may be sequentially disposed on the second protrusion 292-2, between the second protrusion 292-2 and the first protrusion 292-1, and on the first protrusion 292-1.

In the electronic device 200 according to an embodiment, the heat radiating member 270 may be pressed toward the circuit board 240 by the pressing member 291 in the first state and the second state, and thus heat generated from the heat generating part 242 (e.g., the circuit element 242a) may be more effectively transferred to the heat radiating member 270. Since the heat radiating member 270 is pressed by the pressing member 291, the heat radiating member 270 may be brought into close contact with the heat generating part 242 (e.g., the thermally conductive sheet 242b). Accordingly, a separation space between the heat radiating member 270 and the heat generating part 242 may be reduced. Thus, thermal resistance may be reduced, and heat transfer may be smoothly performed.

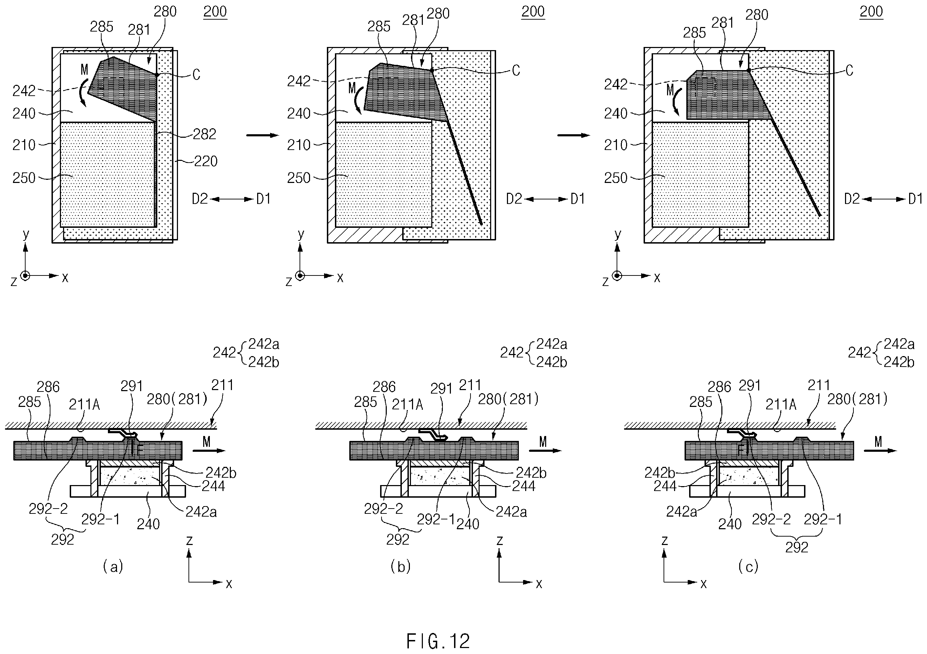

FIG. 12 is a view illustrating an operation between a heat radiating member and a pressing member in a process in which a state of the electronic device is changed according to an embodiment.

FIG. 12 (a) illustrates the heat radiating member and the pressing member when the electronic device is in the first state, FIG. 12 (b) illustrates the heat radiating member and the pressing member when the electronic device is in an intermediate state between the first state and the second state, and FIG. 12 (c) illustrates the heat radiating member and the pressing member when the electronic device is in the second state.

Referring to FIG. 12, the electronic device 200 according to an embodiment (e.g., the electronic device 100 of FIGS. 1 to 3) may include the first structure 210 (e.g., the first structure 110 of FIGS. 1 to 3), the second structure 220 (e.g., the second structure 140 of FIGS. 1 to 3), the circuit board 240 (e.g., the circuit board 170 of FIGS. 1 to 3), the battery 250 (e.g., the battery 180 of FIGS. 1 to 3), and the heat radiating member 280 (e.g., the heat radiating member 160 of FIGS. 1 to 3).

According to the embodiment illustrated in FIG. 12, the electronic device 200 may include the heat radiating member 280 illustrated in FIGS. 9 and 10. FIG. 12 illustrates a pressing operation of the heat radiating member 280 that rotates depending on a sliding operation of the second structure 220. When compared to the above-described heat radiating member of FIG. 11 (e.g., the heat radiating member 270 of FIG. 11), the heat radiating member 280 of FIG. 12 may not linearly move in the direction of movement of the second structure 220, but may rotate about the central axis of rotation C.

In an embodiment, the heat radiating member 280 may rotate relative to the bracket 211 and the circuit board 240 as the second structure 220 slides relative to the first structure 210. The heat radiating member 280 may rotate about the central axis of rotation C within a specified range. As the heat radiating member 280 rotates, the first part 281 of the heat radiating member 280 may relatively move while overlapping the circuit board 230 and the heat generating part 232, and the second part 282 of the heat radiating member 280 may move toward or away from the side surfaces of the circuit board 240 and the battery 250. When the second structure 220 slides, the first part 281 may appear to partially rotate (M) relative to the circuit board 240 and the heat generating part 242. For example, the first part 281 may rotate in a curve about the central axis of rotation C relative to the circuit board 240 and the heat generating part 242 within a specified range.

In an embodiment, the first part 281 of the heat radiating member 280 may include a first surface 285 (e.g., a surface facing in the +z-axis direction) that faces the bracket 211 and a second surface 286 (e.g., a surface facing in the -z-axis direction) that faces away from the first surface 285. The protrusion 292 may protrude to a specified height from the first surface 285 of the heat radiating member 280 toward the bracket 211. The protrusion 292 may include the first protrusion 292-1 making contact with the pressing member 291 in the first state and the second protrusion 292-2 making contact with the pressing member 291 in the second state.

In an embodiment, the pressing member 291 may press the heat radiating member 280 toward the circuit board 240 (e.g., in the -z-axis direction) in the first state (e.g., FIG. 12 (a)) and the second state (e.g., FIG. 12 (c)). Furthermore, the pressing member 291 may be configured so as not to press the heat radiating member 280 in the intermediate state (e.g., FIG. 11 (b)) between the first state and the second state. The pressing member 291 may make contact with the first protrusion 292-1 in the first state and may make contact with the second protrusion 292-2 in the second state.

As illustrated in FIG. 12 (a), in the first state, the pressing member 291 may be compressed by making contact with the first protrusion 292-1. The pressing member 291 in the compressed state may generate an elastic force F toward the heat radiating member 280 (e.g., in the -z-axis direction) and may press the heat radiating member 280 toward the circuit board 240 (e.g., in the -z-axis direction). Accordingly, in the first state, the heat radiating member 280 may remain brought into close contact with the heat generating part 242 (or, the thermally conductive sheet 242b).

As illustrated in FIG. 12 (b), in the intermediate state, the pressing member 291 may be disposed between the first protrusion 292-1 and the second protrusion 292-2. For example, the pressing member 291 may be located between the first protrusion 292-1 and the second protrusion 292-2 as the first part 281 of the heat radiating member 280 moves (M) relative to the bracket 211 when the electronic device 200 is changed from the first state to the second state. The pressing member 291 may not make contact with the first protrusion 292-1 and the second protrusion 292-2 and thus may be uncompressed. The electronic device 200 may be configured such that the pressing member 291 does not press the heat radiating member 280 in the intermediate state, and thus movement of the heat radiating member 280 may not be obstructed.

As illustrated in FIG. 12 (c), in the second state, the pressing member 291 may be compressed by making contact with the second protrusion 292-2. For example, as the first part 281 of the heat radiating member 280 continues to move (M) relative to the bracket 211 in the intermediate state (e.g., FIG. 12 (b)), the pressing member 291 may make contact with the second protrusion 292-2. The pressing member 291 in the compressed state may generate an elastic force F toward the heat radiating member 280 (e.g., in the -z-axis direction) and may press the heat radiating member 280 toward the circuit board 240 (e.g., in the -z-axis direction). Accordingly, in the second state, the heat radiating member 280 may remain brought into close contact with the heat generating part 242 (or, the thermally conductive sheet 242b).

In an embodiment, when the electronic device 200 is changed from the first state to the second state (e.g., changed in the order of FIG. 11 (a), (b), and (c)), the first part 281 may be moved (M) relative to the bracket 211 as the heat radiating member 280 rotates about the central axis of rotation C in the counterclockwise direction, and the pressing member 291 may be sequentially disposed on the first protrusion 292-1, between the first protrusion 292-1 and the second protrusion 292-2, and on the second protrusion 292-2. In contrast, when the electronic device 200 is changed from the second state to the first state (e.g., changed in the order of FIG. 11 (c), (b), and (a)), the first part 281 may be moved relative to the bracket 211 as the heat radiating member 280 rotates about the central axis of rotation C in the clockwise direction, and the pressing member 291 may be sequentially disposed on the second protrusion 292-2, between the second protrusion 292-2 and the first protrusion 292-1, and on the first protrusion 292-1.

According to an embodiment, as described above with reference to FIG. 11, the heat radiating member 280 may be pressed by the pressing member 291 in the first state and the second state and may be brought into close contact with the heat generating part 242 (e.g., the thermally conductive sheet 242b). Accordingly, a separation space between the heat radiating member 270 and the heat generating part 242 may be reduced. Thus, thermal resistance may be reduced, and heat transfer may be smoothly performed.

FIG. 13 is a block diagram of an electronic device in a network environment according to an embodiment.

Referring to Fig. 13, the electronic device 1301 in the network environment 1300 may communicate with an electronic device 1302 via a first network 1398 (e.g., a short-range wireless communication network), or at least one of an electronic device 1304 or a server 1308 via a second network 1399 (e.g., a long-range wireless communication network). According to an embodiment, the electronic device 1301 may communicate with the electronic device 1304 via the server 1308.

According to an embodiment, the electronic device 1301 may include a processor 1320, memory 1330, an input module 1350, a sound output module 1355, a display module 1360, an audio module 1370, a sensor module 1376, an interface 1377, a connecting terminal 1378, a haptic module 1379, a camera module 1380, a power management module 1388, a battery 1389, a communication module 1390, a subscriber identification module(SIM) 1396, or an antenna module 1397. In some embodiments, at least one of the components (e.g., the connecting terminal 1378) may be omitted from the electronic device 1301, or one or more other components may be added in the electronic device 1301. In some embodiments, some of the components (e.g., the sensor module 1376, the camera module 1380, or the antenna module 1397) may be implemented as a single component (e.g., the display module 1360).

The processor 1320 may execute, for example, software (e.g., a program 1340) to control at least one other component (e.g., a hardware or software component) of the electronic device 1301 coupled with the processor 1320, and may perform various data processing or computation. According to one embodiment, as at least part of the data processing or computation, the processor 1320 may store a command or data received from another component (e.g., the sensor module 1376 or the communication module 1390) in volatile memory 1332, process the command or the data stored in the volatile memory 1332, and store resulting data in non-volatile memory 1334. According to an embodiment, the processor 1320 may include a main processor 1321 (e.g., a central processing unit (CPU) or an application processor (AP)), or an auxiliary processor 1323 (e.g., a graphics processing unit (GPU), a neural processing unit (NPU), an image signal processor (ISP), a sensor hub processor, or a communication processor (CP)) that is operable independently from, or in conjunction with, the main processor 1321. For example, when the electronic device 1301 includes the main processor 1321 and the auxiliary processor 1323, the auxiliary processor 1323 may be adapted to consume less power than the main processor 1321, or to be specific to a specified function. The auxiliary processor 1323 may be implemented as separate from, or as part of the main processor 1321.

The auxiliary processor 1323 may control at least some of functions or states related to at least one component (e.g., the display module 1360, the sensor module 1376, or the communication module 1390) among the components of the electronic device 1301, instead of the main processor 1321 while the main processor 1321 is in an inactive (e.g., sleep) state, or together with the main processor 1321 while the main processor 1321 is in an active state (e.g., executing an application). According to an embodiment, the auxiliary processor 1323 (e.g., an image signal processor or a communication processor) may be implemented as part of another component (e.g., the camera module 1380 or the communication module 1390) functionally related to the auxiliary processor 1323. According to an embodiment, the auxiliary processor 1323 (e.g., the neural processing unit) may include a hardware structure specified for artificial intelligence model processing. An artificial intelligence model may be generated by machine learning. Such learning may be performed, e.g., by the electronic device 1301 where the artificial intelligence is performed or via a separate server (e.g., the server 1308). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1330 may store various data used by at least one component (e.g., the processor 1320 or the sensor module 1376) of the electronic device 1301. The various data may include, for example, software (e.g., the program 1340) and input data or output data for a command related thererto. The memory 1330 may include the volatile memory 1332 or the non-volatile memory 1334.

The program 1340 may be stored in the memory 1330 as software, and may include, for example, an operating system (OS) 1342, middleware 1344, or an application 1346.

The input module 1350 may receive a command or data to be used by another component (e.g., the processor 1320) of the electronic device 1301, from the outside (e.g., a user) of the electronic device 1301. The input module 1350 may include, for example, a microphone, a mouse, a keyboard, a key (e.g., a button), or a digital pen (e.g., a stylus pen).

The sound output module 1355 may output sound signals to the outside of the electronic device 1301. The sound output module 1355 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1360 may visually provide information to the outside (e.g., a user) of the electronic device 1301. The display module 1360 may include, for example, a display, a hologram device, or a projector and control circuitry to control a corresponding one of the display, hologram device, and projector. According to an embodiment, the display module 1360 may include a touch sensor adapted to detect a touch, or a pressure sensor adapted to measure the intensity of force incurred by the touch.

In an embodiment, the display module 1360 may include a display (e.g., the flexible display 150 of FIGS. 1 to 3 or the flexible display 230 of FIG. 4) that is slidably disposed to provide a screen (e.g., a display screen). For example, the display area of the electronic device 1301 may refer to an area that is visually exposed to the surface of the electronic device 1301, outputs an image, or displays a screen. The electronic device 1301 may adjust the area and/or size of the display area according to the movement of the sliding plate (not shown) (e.g., the second structure 140 of FIGS. 1 to 3 or the second structure 220 of FIG. 4) or the movement of the display. For example, the electronic device 1301 including the display module 1360 may be of a rollable or slidable type configured to implement selective expansion and/or contraction of a display area by at least partially slidably operating at least a portion (e.g., a housing) of the electronic device 1301. For example, the display module 1360 may be referred to as a slide-out display or an expandable display.

The audio module 1370 may convert a sound into an electrical signal and vice versa. According to an embodiment, the audio module 1370 may obtain the sound via the input module 1350, or output the sound via the sound output module 1355 or a headphone of an external electronic device (e.g., an electronic device 1302) directly (e.g., wiredly) or wirelessly coupled with the electronic device 1301.

The sensor module 1376 may detect an operational state (e.g., power or temperature) of the electronic device 1301 or an environmental state (e.g., a state of a user) external to the electronic device 1301, and then generate an electrical signal or data value corresponding to the detected state. According to an embodiment, the sensor module 1376 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1377 may support one or more specified protocols to be used for the electronic device 1301 to be coupled with the external electronic device (e.g., the electronic device 1302) directly (e.g., wiredly) or wirelessly. According to an embodiment, the interface 1377 may include, for example, a high definition multimedia interface (HDMI), a universal serial bus (USB) interface, a secure digital (SD) card interface, or an audio interface.

A connecting terminal 1378 may include a connector via which the electronic device 1301 may be physically connected with the external electronic device (e.g., the electronic device 1302). According to an embodiment, the connecting terminal 1378 may include, for example, a HDMI connector, a USB connector, a SD card connector, or an audio connector (e.g., a headphone connector).

The haptic module 1379 may convert an electrical signal into a mechanical stimulus (e.g., a vibration or a movement) or electrical stimulus which may be recognized by a user via his tactile sensation or kinesthetic sensation. According to an embodiment, the haptic module 1379 may include, for example, a motor, a piezoelectric element, or an electric stimulator.

The camera module 1380 may capture a still image or moving images. According to an embodiment, the camera module 1380 may include one or more lenses, image sensors, image signal processors, or flashes.

The power management module 1388 may manage power supplied to the electronic device 1301. According to one embodiment, the power management module 1388 may be implemented as at least part of, for example, a power management integrated circuit (PMIC).

The battery 1389 may supply power to at least one component of the electronic device 1301. According to an embodiment, the battery 1389 may include, for example, a primary cell which is not rechargeable, a secondary cell which is rechargeable, or a fuel cell.

The communication module 1390 may support establishing a direct (e.g., wired) communication channel or a wireless communication channel between the electronic device 1301 and the external electronic device (e.g., the electronic device 1302, the electronic device 1304, or the server 1308) and performing communication via the established communication channel. The communication module 1390 may include one or more communication processors that are operable independently from the processor 1320 (e.g., the application processor (AP)) and supports a direct (e.g., wired) communication or a wireless communication. According to an embodiment, the communication module 1390 may include a wireless communication module 1392 (e.g., a cellular communication module, a short-range wireless communication module, or a global navigation satellite system (GNSS) communication module) or a wired communication module 1394 (e.g., a local area network (LAN) communication module or a power line communication (PLC) module). A corresponding one of these communication modules may communicate with the external electronic device via the first network 1398 (e.g., a short-range communication network, such as BluetoothTM, wireless-fidelity (Wi-Fi) direct, or infrared data association (IrDA)) or the second network 1399 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1392 may identify and authenticate the electronic device 1301 in a communication network, such as the first network 1398 or the second network 1399, using subscriber information (e.g., international mobile subscriber identity (IMSI)) stored in the subscriber identification module 1396.

The wireless communication module 1392 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1392 may support a high-frequency band (e.g., the mmWave band) to achieve, e.g., a high data transmission rate. The wireless communication module 1392 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1392 may support various requirements specified in the electronic device 1301, an external electronic device (e.g., the electronic device 1304), or a network system (e.g., the second network 1399). According to an embodiment, the wireless communication module 1392 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (LTL), or a round trip of 1ms or less) for implementing URLLC.

The antenna module 1397 may transmit or receive a signal or power to or from the outside (e.g., the external electronic device) of the electronic device 1301. According to an embodiment, the antenna module 1397 may include an antenna including a radiating element composed of a conductive material or a conductive pattern formed in or on a substrate (e.g., a printed circuit board (PCB)). According to an embodiment, the antenna module 1397 may include a plurality of antennas (e.g., array antennas). In such a case, at least one antenna appropriate for a communication scheme used in the communication network, such as the first network 1398 or the second network 1399, may be selected, for example, by the communication module 1390 (e.g., the wireless communication module 1392) from the plurality of antennas. The signal or the power may then be transmitted or received between the communication module 1390 and the external electronic device via the selected at least one antenna. According to an embodiment, another component (e.g., a radio frequency integrated circuit (RFIC)) other than the radiating element may be additionally formed as part of the antenna module 1397.

According to various embodiments, the antenna module 1397 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1301 and the external electronic device 1304 via the server 1308 coupled with the second network 1399. Each of the electronic devices 1302 or 1304 may be a device of a same type as, or a different type, from the electronic device 1301. According to an embodiment, all or some of operations to be executed at the electronic device 1301 may be executed at one or more of the external electronic devices 1302, 1304, or 1308. For example, if the electronic device 1301 should perform a function or a service automatically, or in response to a request from a user or another device, the electronic device 1301, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1301. The electronic device 1301 may provide the outcome, with or without further processing of the outcome, as at least part of a reply to the request. To that end, a cloud computing, distributed computing, mobile edge computing (MEC), or client-server computing technology may be used, for example. The electronic device 1301 may provide ultra low-latency services using, e.g., distributed computing or mobile edge computing. In another embodiment, the external electronic device 1304 may include an internet-of-things (IoT) device. The server 1308 may be an intelligent server using machine learning and/or a neural network. According to an embodiment, the external electronic device 1304 or the server 1308 may be included in the second network 1399. The electronic device 1301 may be applied to intelligent services (e.g., smart home, smart city, smart car, or healthcare) based on 5G communication technology or IoT-related technology.

An electronic device 100 or 200 according to an embodiment of the disclosure may include a first structure 110 or 210, a second structure 140 or 220 coupled to the first structure 110 or 210 so as to slide, a flexible display 150 or 230 that is disposed on the second structure 140 or 220 to move together with the second structure 140 or 220 and that includes a first region 151 or 231 that forms a front surface of the electronic device 100 or 200 and a second region 152 or 232 that extends from the first region 151 or 231, a circuit board 170 or 240 that is coupled to the first structure 110 or 210 and that has a heat generating part 194 or 242 disposed thereon, and a heat radiating member 160 or 260 that is disposed to face the circuit board 170 or 240 and that diffuses heat generated from the heat generating part 194 or 242 and partially overlaps the heat generating part 194 or 242 when the front surface of the electronic device 100 or 200 is viewed from above. The electronic device 100 or 200 may include a first state in which the second region 152 or 232 is located in the first structure 110 or 210 and a second state in which at least a portion of the second region forms the front surface of the electronic device 100 or 200 together with the first region 151 or 231. When the electronic device 100 or 200 is changed to the first state and the second state by the sliding of the second structure 140 or 220, at least a portion of the heat radiating member 160 or 260 may move together with a portion of the second structure 140 or 220 in a direction of the sliding D 1 or D2.

In various embodiments, at least a portion of the heat radiating member 260, 270, or 280 may make contact with the heat generating part 242, and the heat radiating member 260, 270, or 280 may remain in contact with the heat generating part 242 when moved by the sliding of the second structure 220.

In various embodiments, the heat radiating member 260, 270, or 280 may be configured such that the heat generating part 242 is brought into contact with one partial region of the heat radiating member 260, 270, or 280 in the first state and is brought into contact with another partial region of the heat radiating member 260, 270, or 280 in the second state.

In various embodiments, the first structure 210 may include a bracket 211 that is disposed to face the circuit board 240 and that supports the circuit board and 240 and a battery 250, and the heat radiating member 270 may be disposed between the bracket 211 and the circuit board 240.

In various embodiments, the heat radiating member 270 may include a first surface 261 that faces the bracket 211 and a second surface that faces away from the first surface 261 and face the circuit board 240, and a pressing member 291 may be disposed between the first surface 261 of the heat radiating member 260 and the bracket 211.

In various embodiments, the pressing member 291 between the heat radiating member 270 and the bracket 211 may be elastically deformed in response to movement of the heat radiating member 270.

In various embodiments, the pressing member 291 may press the heat radiating member 270 toward the circuit board 240 in the first state and the second state.

In various embodiments, the heat radiating member 270 may include a protrusion 292 that protrudes to a predetermined height from the first surface 271 of the heat radiating member 270 toward the bracket 211, and the protrusion 292 may include a first protrusion 292-1 that makes contact with the pressing member 291 in the first state and a second protrusion 292-2 that makes contact with the pressing member 291 in the second state.

In various embodiments, the pressing member 291 may be deformed into a compressed state by contact with the protrusion 292, and the pressing member 291 in the compressed state may provide an elastic force F to the heat radiating member 260 and may press the heating member 260.

In various embodiments, the pressing member 291 may be located between the first protrusion 292-1 and the second protrusion 292-2 in an intermediate state between the first state and the second state. The intermediate state may be defined as a state between the first state and the second state when the electronic device is changed from the first state to the second state or a state between the second state and the first state when the electronic device is changed from the second state to the first state.

In various embodiments, when the electronic device is changed from the first state to the second state, a portion of the second structure 220 and the first region 231 of the flexible display 230 may move relative to the first structure 210 in a first direction D1 and may form an extended region 202 of the electronic device 200.

In various embodiments, the heat radiating member 260 may be configured such that at least a portion of the heat radiating member 260 is located in the extended region 202 in the second state.

In various embodiments, the heat radiating member 260 may move together with a portion of the second structure 220 and the first region 231 in the first direction D 1 and a second direction D2 opposite to the first direction D 1.

In various embodiments, the heat radiating member 260 may include a first contact region 264 that partially makes contact with the heat generating part 242 in the first state and a second contact region 263 that partially makes contact with the heat generating part 242 in the second state, and at least a portion of the first contact region 264 may be located in the extended region 202 in the second state.

In various embodiments, the heat radiating member 270 may include a first plate 270-1 and a second plate 270-2 that remains in contact with the first plate 270-1. The first plate 270-1 may move in the first direction D1 and the second direction D2 depending on the sliding of the second structure 220. The second plate 270-2 may be fixed to the circuit board 240 or the first structure 210.

In various embodiments, at least a portion of the first plate 270-1 may be located in the extended region 202 in the second state.

In various embodiments, the heat radiating member 280 may rotate about a virtual central axis of rotation C within a predetermined range depending on the sliding of the second structure 220, and the central axis of rotation C may penetrate one surface of the heat radiating member 280 and one surface of the circuit board 240 in a vertical direction.

In various embodiments, the heat radiating member 280 may include a first part 281 that makes contact with the heat generating part 242 and a second part 282 that is perpendicular to the first part 281 and extends a predetermined length, and at least a portion of the second part 282 may be located in the extended region 202 in the second state.

An electronic device according to an embodiment of the disclosure may include a first structure including a case and a bracket disposed in the case, a second structure that is connected to the first structure so as to slide and that surrounds at least a portion of the bracket, a flexible display that is disposed on the second structure and that moves together with the second structure, the flexible display including a first region that forms a front surface of the electronic device and a second region that extends from the first region such that at least a portion of the second region is accommodated in a space between the bracket and the case, a roller that is disposed on one side of the bracket so as to be rotatable about a rolling axis and that rotates a portion of the second structure, a circuit board that is fixed to the first structure to face the bracket and that has a heat generating part disposed on at least a portion of the circuit board, and a heat radiating member that is disposed between the bracket and the circuit board and that makes contact with the heat generating part and moves relative to the circuit board while making contact with the heat generating part depending on the sliding of the second structure. The electronic device may include a first state in which the second region is located in the case and a second state in which at least a portion of the second region forms the front surface of the electronic device together with the first region. When the electronic device is changed to the first state and the second state by the sliding of the second structure, at least a portion of the heat radiating member may move together with a portion of the second structure in a direction of the sliding.

In various embodiments, a pressing member 291 capable of elastic deformation may be disposed between the heat radiating member 270 or 280 and the bracket 211. The pressing member 281 may press the heat radiating member 270 or 280 toward the circuit board 240 in the first state and the second state. The heat radiating member 270 or 280 may include a first protrusion 292-1 that makes contact with the pressing member 291 in the first state and a second protrusion 292-2 that makes contact with the pressing member 291 in the second state.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1340) including one or more instructions that are stored in a storage medium (e.g., internal memory 1336 or external memory 1338) that is readable by a machine (e.g., the electronic device 100, 200, 1301). For example, a processor (e.g., the processor 194, 1320) of the machine (e.g., the electronic device 100, 200, 1301) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a first structure;
a second structure coupled to the first structure so as to slide;
a flexible display disposed on the second structure to move together with the second structure, the flexible display including a first region configured to form a front surface of the electronic device and a second region configured to extend from the first region;
a circuit board coupled to the first structure, the circuit board having a heat generating part disposed thereon; and
a heat radiating member disposed to face the circuit board and configured to diffuse heat generated from the heat generating part, wherein the heat radiating member partially overlaps the heat generating part when the front surface of the electronic device is viewed from above,
wherein the electronic device includes a first state in which the second region is located in the first structure and a second state in which at least a portion of the second region forms the front surface of the electronic device together with the first region, and
wherein when the electronic device is changed to the first state and the second state by the sliding of the second structure, at least a portion of the heat radiating member moves together with a portion of the second structure in a direction of the sliding.

2. The electronic device of claim 1, wherein at least a portion of the heat radiating member makes contact with the heat generating part, and the heat radiating member remains in contact with the heat generating part when moved by the sliding of the second structure.

3. The electronic device of claim 1, wherein the heat radiating member is configured such that the heat generating part is brought into contact with one partial region of the heat radiating member in the first state and is brought into contact with another partial region of the heat radiating member in the second state.

4. The electronic device of claim 1, wherein the first structure includes a bracket disposed to face the circuit board and configured to support the circuit board and a battery, and
wherein the heat radiating member is disposed between the bracket and the circuit board.

5. The electronic device of claim 4, wherein the heat radiating member includes a first surface configured to face the bracket and a second surface configured to face away from the first surface and face the circuit board, and
wherein a pressing member is disposed between the first surface of the heat radiating member and the bracket.

6. The electronic device of claim 5, wherein the pressing member between the heat radiating member and the bracket is elastically deformed in response to movement of the heat radiating member.

7. The electronic device of claim 6, wherein the pressing member presses the heat radiating member toward the circuit board in the first state and the second state.

8. The electronic device of claim 6, wherein the heat radiating member includes a protrusion configured to protrude to a predetermined height from the first surface of the heat radiating member toward the bracket, and
wherein the protrusion includes a first protrusion configured to make contact with the pressing member in the first state and a second protrusion configured to make contact with the pressing member in the second state.

9. The electronic device of claim 8, wherein the pressing member is deformed into a compressed state by contact with the protrusion, and
wherein the pressing member in the compressed state provides an elastic force to the heat radiating member and presses the heating member.

10. The electronic device of claim 8, wherein the pressing member is located between the first protrusion and the second protrusion in an intermediate state between the first state and the second state, and
wherein the intermediate state is defined as a state between the first state and the second state when the electronic device is changed from the first state to the second state or a state between the second state and the first state when the electronic device is changed from the second state to the first state.

11. The electronic device of claim 1, wherein when the electronic device is changed from the first state to the second state, a portion of the second structure and the first region of the flexible display move relative to the first structure in a first direction and form an extended region of the electronic device.

12. The electronic device of claim 11, wherein the heat radiating member is configured such that at least a portion of the heat radiating member is located in the extended region in the second state.

13. The electronic device of claim 12, wherein the heat radiating member includes a first contact region configured to partially make contact with the heat generating part in the first state and a second contact region configured to partially make contact with the heat generating part in the second state, and
wherein at least a portion of the first contact region is located in the extended region in the second state.

14. The electronic device of claim 12, wherein the heat radiating member includes a first plate and a second plate configured to remain in contact with the first plate,
wherein the first plate moves in the first direction and a direction opposite to the first direction depending on the sliding of the second structure, and
wherein the second plate is fixed to the circuit board or the first structure.

15. The electronic device of claim 12, wherein the heat radiating member rotates about a virtual central axis of rotation within a predetermined range depending on the sliding of the second structure, and
wherein the central axis of rotation penetrates one surface of the heat radiating member and one surface of the circuit board in a vertical direction.
